# EUROPEAN PATENT APPLICATION

(11) **EP 4 818 356 A1**
(43) Date of publication of application: **07.10.2026**
(21) Application number: 24897342.2
(22) Date of filing: 15.11.2024
(51) Int. Cl.: C23C 14/04, H10K 59/10, H10K 71/00, H10K 71/16

(54) **CONNECTION APPARATUS AND CONNECTION METHOD**

(30) Priority: 28.11.2023 JP 2023201107
(71) Applicant: Dai Nippon Printing Co., Ltd., Tokyo 162-8001 (JP)
(72) Inventor: AMIE Takashi, Tokyo 162-8001 (JP); OBATA Katsunari, Tokyo 162-8001 (JP); HOKARI Kumiko, Tokyo 162-8001 (JP); KIURA Shinya, Tokyo 162-8001 (JP)
(74) Representative: Müller-Boré & Partner Patentanwälte PartG mbB
(86) International application number: PCT/JP2024/040671
(87) International publication number: WO 2025/115655

(57) **Abstract**

A connection apparatus connects a frame to a mask. The connection apparatus includes a first pressing plate, a suction device, a second pressing plate, and a pressing device. The first pressing plate includes a first support surface for supporting the mask. The first pressing plate is provided with a first suction hole that opens in the first support surface. The suction device is configured to suction an inside of the first suction hole. The second pressing plate includes a second support surface for supporting the frame. The second support surface is to face the first support surface. The pressing device is configured to move the first pressing plate and/or the second pressing plate to press the first pressing plate and the second pressing plate against each other.

## Description

### Technical Field

Embodiments of the present disclosure relate to a connection apparatus and a connection method for connecting a frame to a mask.

### Background Art

A vapor deposition method is known as a method for forming a precise pattern. In the vapor deposition method, first, a mask having openings formed therein is combined with a substrate. Subsequently, a vapor deposition material is deposited on the substrate through the openings of the mask. As a result, a vapor deposition layer containing the vapor deposition material is formed on the substrate in a pattern corresponding to a pattern of the openings of the mask. The vapor deposition method is used, for example, as a method for forming pixels of an organic EL display device. Patent Literature 1 discloses a mask used in the vapor deposition method.

### Citation List

### Patent Literature

PTL 1: Japanese Unexamined Patent Application Publication No. 2009-062565

### Summary of Invention

### Technical Problem

When openings are formed up to the vicinity of the outer edge of a mask, an outer edge portion of the mask is easily damaged, and handling the mask becomes difficult. In addition, when the openings are formed up to the vicinity of the outer edge, the outer edge portion of the mask is narrow. As a result, when the mask is gripped, not only the outer edge portion but also a region inside the outer edge portion, that is, a region in which the openings of the mask are formed, may be gripped. In this case, the region in which the openings of the mask are formed may be contaminated. On the other hand, it is required to enable a vapor deposition layer to be formed over a wider range of a substrate with a single mask by forming the openings up to the vicinity of the outer edge of the mask.

It is conceivable to suppress damage to the mask by attaching a frame to the outer edge portion of the mask. However, if the mask is attached to the frame in a bent or distorted state, a large gap may be formed between the mask and the substrate in a vapor deposition step. If the gap is formed, there is a concern that a vapor deposition material cannot be accurately deposited on the substrate. In fact, according to the knowledge obtained by the present inventors, in a framed mask fabricated by manually connecting a mask to a frame, the surface of the mask that is intended to face the substrate is not flat. For example, the difference in height of each part of the surface of the mask that is intended to face the substrate is 50 µm or more at the maximum value. Therefore, it is required to improve the flatness of the mask in the framed mask.

An object of embodiments of the present disclosure is to provide a connection apparatus and a connection method that can effectively solve such a problem.

### Solution to Problem

A connection apparatus according to an embodiment of the present disclosure is a connection apparatus for connecting a frame to an outer region of a mask that includes an inner region in which a plurality of openings are formed and the outer region surrounding the inner region. The connection apparatus may include a first pressing plate including a first support surface for supporting the mask, the first pressing plate being provided with a first suction hole that opens in the first support surface; a suction device configured to suction an inside of the first suction hole; a second pressing plate including a second support surface for supporting the frame, the second support surface facing toward the first support surface; and a pressing device configured to move the first pressing plate and/or the second pressing plate to press the first pressing plate and the second pressing plate against each other.

A connection method according to an embodiment of the present disclosure is a connection method for connecting a frame to an outer region of a mask that includes an inner region in which a plurality of openings are formed and the outer region surrounding the inner region, by using the connection apparatus according to the above embodiment. The connection method may include a step of disposing the mask on the first support surface of the first pressing plate and holding the mask on the first support surface by suctioning the inside of the first suction hole by the suction device; a step of disposing the frame on the second support surface of the second pressing plate; a step of forming a connection layer in the outer region of the mask or in a region of the frame that is to face the outer region; and a step of connecting the mask and the frame via the connection layer by moving the first pressing plate on which the mask is held by suction and/or the second pressing plate supporting the frame by the pressing device to press the first pressing plate and the second pressing plate against each other.

A connection apparatus according to a modification of the embodiment of the present disclosure is a connection apparatus for connecting a frame to an outer region of a mask that includes an inner region in which a plurality of openings are formed and the outer region surrounding the inner region. The connection apparatus may include a first pressing plate including a first support surface for supporting the mask; a second pressing plate including a second support surface for supporting the frame, the second support surface facing toward the first support surface; and a pressing device configured to move the first pressing plate and/or the second pressing plate to press the first pressing plate and the second pressing plate against each other, wherein at least a part of the first support surface of the first pressing plate may be covered with a bonding layer.

A connection method according to a modification of the embodiment of the present disclosure is a connection method for connecting a frame to an outer region of a mask that includes an inner region in which a plurality of openings are formed and the outer region surrounding the inner region, by using the connection apparatus according to the modification of the above embodiment. The connection method may include a step of disposing the mask on the first support surface of the first pressing plate and bonding the mask to the bonding layer; a step of disposing the frame on the second support surface of the second pressing plate; a step of forming a connection layer in the outer region of the mask or in a region of the frame that is to face the outer region; and a step of connecting the mask and the frame via the connection layer by moving the first pressing plate to which the mask is bonded and/or the second pressing plate supporting the frame by the pressing device to press the first pressing plate and the second pressing plate against each other.

### Advantageous Effects of Invention

According to the embodiments of the present disclosure, it is possible to improve the flatness of a mask in a framed mask.

### Brief Description of Drawings

[Fig. 1] Fig. 1 is a cross-sectional view illustrating an example of an organic device.
[Fig. 2] Fig. 2 is a view illustrating an example of a vapor deposition apparatus provided with a framed mask.
[Fig. 3] Fig. 3 is a plan view illustrating an example of a framed mask as viewed from an entrance surface side.
[Fig. 4] Fig. 4 is a plan view illustrating an example of the framed mask as viewed from an exit surface side.
[Fig. 5A] Fig. 5A is a cross-sectional view of the framed mask in Fig. 3 taken along line V-V.
[Fig. 5B] Fig. 5B is an enlarged view of a portion enclosed by the two-dot chain line in the cross section illustrated in Fig. 5A.
[Fig. 6A] Fig. 6A is a cross-sectional view illustrating the overall configuration of a connection apparatus.
[Fig. 6B] Fig. 6B is a cross-sectional view illustrating the overall configuration of the connection apparatus.
[Fig. 6C] Fig. 6C is a cross-sectional view illustrating the overall configuration of the connection apparatus.
[Fig. 6D] Fig. 6D is a cross-sectional view illustrating the overall configuration of the connection apparatus.
[Fig. 6E] Fig. 6E is a cross-sectional view illustrating the overall configuration of the connection apparatus.
[Fig. 7] Fig. 7 is an enlarged view of a portion enclosed by the two-dot chain line in the cross section illustrated in Fig. 6A.
[Fig. 8A] Fig. 8A is a plan view illustrating an example of a first support surface of a first pressing plate.
[Fig. 8B] Fig. 8B is a plan view illustrating an example of the first support surface of the first pressing plate.
[Fig. 9] Fig. 9 is a plan view illustrating an example of a second support surface of a second pressing plate.
[Fig. 10] Fig. 10 is a view corresponding to Fig. 7 and illustrating a modification of the connection apparatus.
[Fig. 11] Fig. 11 is a view corresponding to Fig. 7 and illustrating a modification of the connection apparatus.
[Fig. 12] Fig. 12 is a view corresponding to Fig. 7 and illustrating a modification of the connection apparatus.

### Description of Embodiments

In the present specification and the drawings, unless otherwise specified, terms such as "substrate", "sheet", and "film", which mean a substance serving as a base of a certain configuration, are not distinguished from one another based solely on the difference in name.

In the present specification and the drawings, unless otherwise specified, terms such as "parallel" and "orthogonal", values of length and angle, and the like, which specify shapes, geometric conditions, and degrees thereof, are not to be construed in their strict sense and are interpreted to an extent that the same or similar functions may be expected.

In the present specification and the drawings, unless otherwise specified, when an element such as a member or a region is "on" or "beneath", "over" or "under", or "above" or "below" another element such as another member or another region, this includes not only cases where the two elements are in direct contact with each other, but also cases where one or more additional elements are interposed between them, that is, cases where the two elements are in indirect contact with each other. In addition, unless otherwise specified, the terms "on", "over", "above", "beneath", "under", and "below" may be interpreted with the vertical direction reversed.

In the present specification and the drawings, unless otherwise specified, a state where a surface of an element A "faces" a surface of an element B includes not only a case where the surface of the element A is in contact with the surface of the element B, but also a case where an element C is positioned between the surface of the element A and the surface of the element B. That is, the term "face" represents the orientation of two surfaces.

In this specification and the drawings, the same portions or portions having similar functions are denoted by the same reference signs or similar reference signs unless otherwise specified, and repeated description thereof may be omitted. In addition, for convenience of description, a dimensional ratio in the drawings may be different from the actual ratio, or a part of the configuration may be omitted from the drawings.

In the present specification and the drawings, unless otherwise specified, one embodiment of the present specification can be combined with another example as long as no contradiction occurs. In addition, other examples may be combined with each other as long as no contradiction occurs.

In the present specification and the drawings, when two or more steps or processes relating to a method such as the manufacturing method are disclosed, unless otherwise specified, other steps or processes that are not disclosed may be performed between the disclosed steps or processes. In addition, the disclosed steps or processes may be performed in any order as long as no contradiction occurs.

In an example described according to an embodiment of the present specification, a mask is used to form an organic layer or an electrode on a substrate when an organic EL display device is manufactured. However, the application of the mask is not particularly limited, and the present embodiment can be applied to masks used for various applications. For example, the mask according to the present embodiment may be used to form an electrode of a device for displaying or projecting an image or video for expressing virtual reality, so-called VR, or augmented reality, so-called AR. The mask according to the present embodiment may be used to form an electrode of a display device other than an organic EL display device, such as an electrode of a liquid crystal display device. The mask according to the present embodiment may be used to form an electrode of an organic device other than a display device, such as an electrode of a pressure sensor.

A first aspect of the present disclosure is a connection apparatus for connecting a frame to an outer region of a mask that includes an inner region in which a plurality of openings are formed and the outer region surrounding the inner region, the connection apparatus including:
a first pressing plate including a first support surface for supporting the mask, the first pressing plate being provided with a first suction hole that opens in the first support surface;
a suction device configured to suction an inside of the first suction hole;
a second pressing plate including a second support surface for supporting the frame, the second support surface facing toward the first support surface; and
a pressing device configured to move the first pressing plate and/or the second pressing plate to press the first pressing plate and the second pressing plate against each other.

In a connection apparatus according to a second aspect in accordance with the first aspect described above, at least a part of the first support surface of the first pressing plate may be covered with a porous layer.

In a connection apparatus according to a third aspect in accordance with the first aspect or the second aspect described above,
the second pressing plate may be provided with a second suction hole that opens in the second support surface, and
the suction device may be configured to suction an inside of the second suction hole.

A fourth aspect of the present disclosure is a connection apparatus for connecting a frame to an outer region of a mask that includes an inner region in which a plurality of openings are formed and the outer region surrounding the inner region, the connection apparatus including:
a first pressing plate including a first support surface for supporting the mask;
a second pressing plate including a second support surface for supporting the frame, the second support surface facing toward the first support surface; and
a pressing device configured to move the first pressing plate and/or the second pressing plate to press the first pressing plate and the second pressing plate against each other,
wherein at least a part of the first support surface of the first pressing plate is covered with a bonding layer.

In a connection apparatus according to a fifth aspect in accordance with the fourth aspect described above,
the second pressing plate may be provided with a second suction hole that opens in the second support surface, and
the connection apparatus may further include a suction device configured to suction an inside of the second suction hole.

In a connection apparatus according to a sixth aspect in accordance with any one of the first aspect to the fifth aspect described above, a first recess that accommodates at least a part of the mask in a thickness direction thereof may be formed in the first support surface.

In a connection apparatus according to a seventh aspect in accordance with the sixth aspect described above, a depth of the first recess may be greater than 0 µm and 1000 µm or less.

In a connection apparatus according to an eighth aspect in accordance with any one of the first aspect to the seventh aspect described above, a second recess that accommodates at least a part of the frame in a thickness direction thereof may be formed in the second support surface.

In a connection apparatus according to a ninth aspect in accordance with the eighth aspect described above, a depth of the second recess may be greater than 0 µm and 30 mm or less.

A connection apparatus according to a tenth aspect in accordance with any one of the first aspect to the ninth aspect described above may further include one or more heaters provided inside the first pressing plate and/or the second pressing plate.

A connection apparatus according to an eleventh aspect in accordance with any one of the first aspect to the tenth aspect described above may further include:
a chamber that accommodates the first pressing plate and the second pressing plate; and
a pressure reducing device configured to reduce a pressure in the chamber.

In a connection apparatus according to a twelfth aspect in accordance with any one of the first aspect to the eleventh aspect described above,
the second pressing plate may be provided with an alignment opening penetrating through the second pressing plate in a thickness direction thereof, and
the connection apparatus may further include an alignment camera configured to capture an image between the second support surface and the first support surface through the alignment opening.

A thirteenth aspect of the present disclosure is a connection method for connecting a frame to an outer region of a mask that includes an inner region in which a plurality of openings are formed and the outer region surrounding the inner region, by using the connection apparatus according to the first aspect, the connection method including:
a step of disposing the mask on the first support surface of the first pressing plate and holding the mask on the first support surface by suctioning the inside of the first suction hole by the suction device;
a step of disposing the frame on the second support surface of the second pressing plate;
a step of forming a connection layer in the outer region of the mask or in a region of the frame that is to face the outer region; and
a step of connecting the mask and the frame via the connection layer by moving the first pressing plate on which the mask is held by suction and/or the second pressing plate supporting the frame by the pressing device to press the first pressing plate and the second pressing plate against each other.

A connection method according to a fourteenth aspect in accordance with the thirteenth aspect described above may further include a step of stopping suction of the inside of the first suction hole by the suction device after connecting the mask and the frame.

A fifteenth aspect of the present disclosure is a connection method for connecting a frame to an outer region of a mask that includes an inner region in which a plurality of openings are formed and the outer region surrounding the inner region, by using the connection apparatus according to the fourth aspect, the connection method including:
a step of disposing the mask on the first support surface of the first pressing plate and bonding the mask to the bonding layer;
a step of disposing the frame on the second support surface of the second pressing plate;
a step of forming a connection layer in the outer region of the mask or in a region of the frame that is to face the outer region; and
a step of connecting the mask and the frame via the connection layer by moving the first pressing plate to which the mask is bonded and/or the second pressing plate supporting the frame by the pressing device to press the first pressing plate and the second pressing plate against each other.

In a connection method according to a sixteenth aspect in accordance with any one of the thirteenth aspect to the fifteenth aspect described above,
the second pressing plate may be provided with a second suction hole that opens in the second support surface,
the connection apparatus may include a suction device configured to suction an inside of the second suction hole, and
the connection method may further include a step of suctioning the inside of the second suction hole by the suction device after disposing the frame on the second pressing plate.

In a connection method according to a seventeenth aspect in accordance with any one of the thirteenth aspect to the sixteenth aspect described above,
one or more heaters may be provided inside the first pressing plate and/or the second pressing plate, and
during the step of pressing the first pressing plate and the second pressing plate against each other, the first pressing plate and/or the second pressing plate may be heated by the one or more heaters.

In a connection method according to an eighteenth aspect in accordance with any one of the thirteenth aspect to the seventeenth aspect described above,
the connection apparatus may further include
a chamber that accommodates the first pressing plate and the second pressing plate, and
a pressure reducing device configured to reduce a pressure in the chamber, and
during the step of pressing the first pressing plate and the second pressing plate against each other, the pressure in the chamber may be reduced by the pressure reducing device.

In a connection method according to a nineteenth aspect in accordance with any one of the thirteenth aspect to the eighteenth aspect described above,
alignment marks may be formed on the mask and the frame,
the second pressing plate may be provided with an alignment opening penetrating through the second pressing plate in a thickness direction thereof,
the connection apparatus may further include an alignment camera configured to capture an image between the second support surface and the first support surface through the alignment opening, and
during the step of disposing the frame on the second support surface of the second pressing plate, alignment of the mask and the frame may be performed by capturing an image of the alignment marks of the mask and the frame with the alignment camera through the alignment opening.

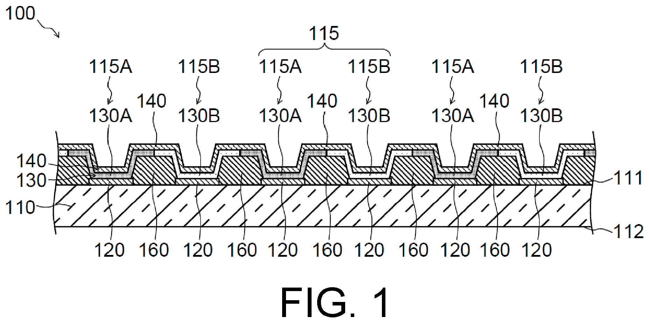

An embodiment will be described with reference to Figs. 1 to 9. First, an organic device 100 including an organic layer formed by using a mask will be described. Fig. 1 is a cross-sectional view illustrating an example of the organic device 100.

The organic device 100 includes a substrate 110 and a plurality of elements 115 arranged in an in-plane direction of the substrate 110. The substrate 110 includes a first surface 111 and a second surface 112 located on an opposite side of the first surface 111. The elements 115 are located on the first surface 111. The elements 115 are, for example, pixels. The substrate 110 may be provided with two or more types of elements 115. For example, the substrate 110 may be provided with first elements 115A and second elements 115B. Although not illustrated, the substrate 110 may be provided with third elements. The first elements 115A, the second elements 115B, and the third elements are, for example, red pixels, blue pixels, and green pixels, respectively.

The elements 115 may each include a first electrode 120, an organic layer 130 located on the first electrode 120, and a second electrode 140 located on the organic layer 130.

The organic device 100 may include an insulating layer 160 located between two first electrodes 120 that are disposed next to each other in plan view. The insulating layer 160 contains, for example, polyimide. The insulating layer 160 may overlap with end portions of the first electrodes 120. The expression "in plan view" means viewing an object in the normal direction of a surface of a plate-like member such as the substrate 110.

The substrate 110 may be a member having insulating properties. Examples of materials for the substrate 110 may include a non-flexible rigid material such as silicon, quartz glass, Pyrex (registered trademark) glass, or a synthetic quartz plate, and a flexible material having flexibility such as a resin film, an optical resin plate, or thin glass. The substrate 110 may have a planar shape similar to that of a silicon wafer used in semiconductor manufacturing. In this case, the substrate 110 can be processed using an apparatus for performing a semiconductor manufacturing process. For example, the first electrodes 120, the insulating layer 160, and the like can be formed on the substrate 110 using an apparatus for performing a semiconductor manufacturing process.

Each of the elements 115 is configured to realize a certain function when a voltage is applied between the first electrode 120 and the second electrode 140 or when a current flows between the first electrode 120 and the second electrode 140. For example, when the elements 115 are pixels of an organic EL display device, the elements 115 can emit light that constitutes an image.

The first electrode 120 contains an electrically conductive material. For example, the first electrode 120 contains a metal, a conductive metal oxide, another conductive inorganic material, or the like. The first electrode 120 may contain a metal oxide having transparency and conductivity, such as indium tin oxide.

The organic layer 130 contains an organic material. When the organic layer 130 is energized, the organic layer 130 can perform a certain function. The "energization" means that a voltage is applied to the organic layer 130 or a current flows through the organic layer 130. Examples of the organic layer 130 may include a light-emitting layer that emits light upon energization, and a layer whose light transmittance or refractive index changes with energization. The organic layer 130 may contain organic semiconductor material.

As illustrated in Fig. 1, the organic layer 130 may include a first organic layer 130A and a second organic layer 130B. The first organic layer 130A is included in each of the first elements 115A. The second organic layer 130B is included in each of the second elements 115B. Although not illustrated, the organic layer 130 may include a third organic layer included in each of the third elements. The first organic layer 130A, the second organic layer 130B, and the third organic layer are, for example, a red light-emitting layer, a blue light-emitting layer, and a green light-emitting layer, respectively.

When a voltage is applied between the first electrode 120 and the second electrode 140, the organic layer 130 positioned between them is driven. When the organic layer 130 is a light-emitting layer, light is emitted from the organic layer 130, and the light is extracted to the outside from the second electrode 140 side or the first electrode 120 side.

The organic layer 130 may further include a hole injection layer, a hole transport layer, an electron transport layer, an electron injection layer, and the like.

The second electrode 140 may contain an electrically conductive material, such as a metal. Examples of materials for the second electrode 140 may include platinum, gold, silver, copper, iron, tin, chromium, aluminum, indium, lithium, sodium, potassium, calcium, magnesium, carbon, or the like, or an alloy thereof. As illustrated in Fig. 1, the second electrode 140 may extend across two organic layers 130 that are disposed next to each other in plan view.

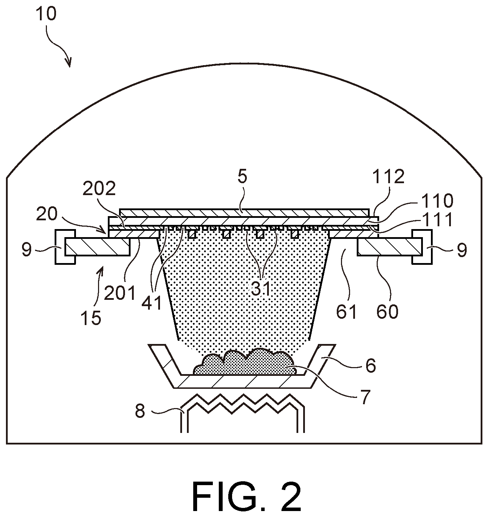

Next, a method for forming the organic layer 130 on the substrate 110 by a vapor deposition method will be described. Fig. 2 is a view illustrating a vapor deposition apparatus 10. The vapor deposition apparatus 10 performs a vapor deposition process for depositing a vapor deposition material on an object.

As illustrated in Fig. 2, the vapor deposition apparatus 10 may include a vapor deposition source 6, a heater 8, and a framed mask 15 therein. The vapor deposition apparatus 10 may further include evacuation means for creating a vacuum atmosphere inside the vapor deposition apparatus 10. The vapor deposition source 6 is, for example, a crucible. The vapor deposition source 6 contains a vapor deposition material 7 such as an organic material or a metal material. The heater 8 heats the vapor deposition source 6 to evaporate the vapor deposition material 7 under the vacuum atmosphere.

The framed mask 15 includes a mask 20 and a frame 60 attached to the mask 20. The mask 20 includes an entrance surface 201, an exit surface 202, and second openings 41. The exit surface 202 is located on an opposite side of the entrance surface 201. The framed mask 15 is supported by a mask holder 9. The framed mask 15 is disposed such that the entrance surface 201 faces the vapor deposition source 6 and the exit surface 202 faces the first surface 111 of the substrate 110. A part of the vapor deposition material 7 that has entered the mask 20 from the entrance surface 201 passes through the second openings 41 and exits from the exit surface 202. The vapor deposition material 7 exited from the exit surface 202 adheres to the first surface 111 of the substrate 110. The exit surface 202 of the mask 20 may be in contact with the first surface 111 of the substrate 110.

As illustrated in Fig. 2, the vapor deposition apparatus 10 may include a magnet 5 disposed on a second surface 112 side of the substrate 110. When the mask 20 contains a metal material, the magnet 5 can attract the mask 20 toward the substrate 110 by magnetic force, thereby making it possible to reduce or eliminate a gap between the mask 20 and the substrate 110. As a result, occurrence of a shadow in the vapor deposition step can be suppressed. In the present application, the term "shadow" refers to a phenomenon in which the organic layer 130 formed in a second opening 41 has a smaller thickness in the vicinity of a wall surface of the second opening 41 than at the center of the same second opening 41. The shadow occurs due to, for example, adhesion of the vapor deposition material 7 to the wall surface of the mask 20 or entry of the vapor deposition material 7 into the gap between the mask 20 and the substrate 110.

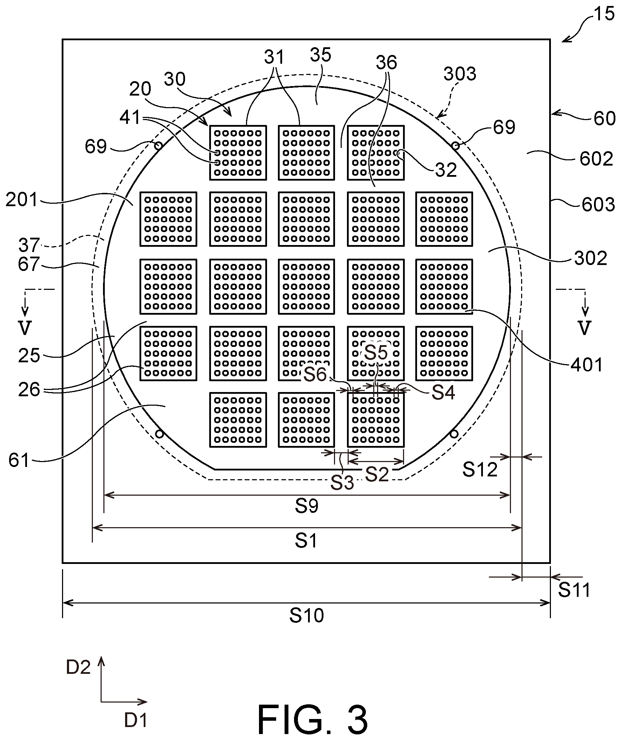

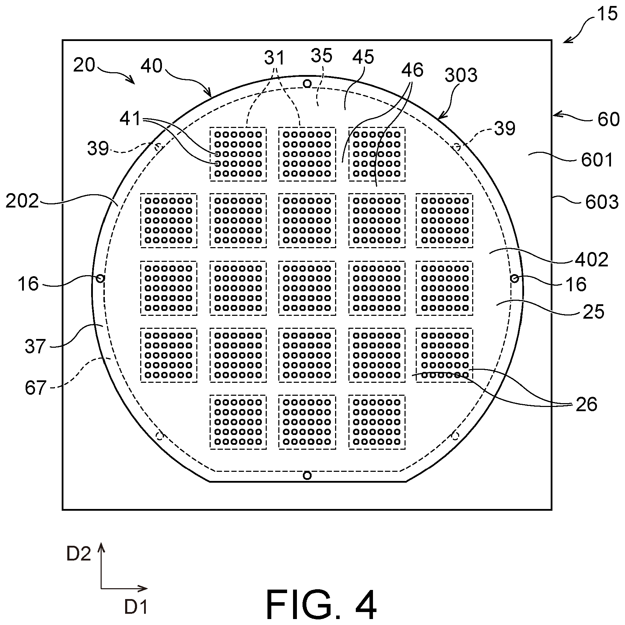

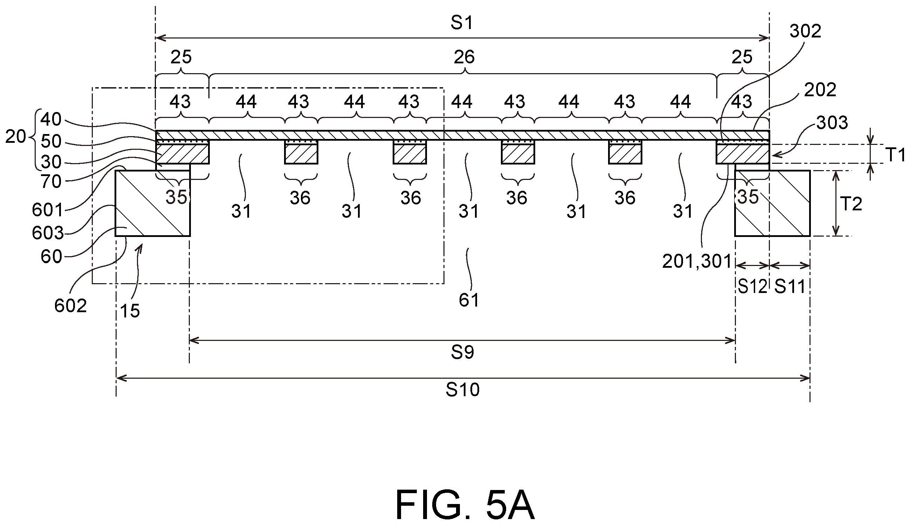

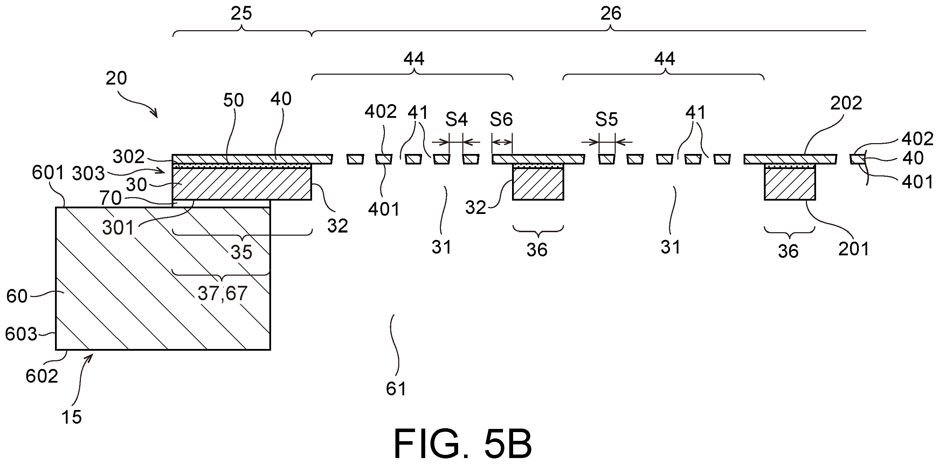

Next, the framed mask 15 will be described in detail. Fig. 3 is a plan view illustrating an example of the framed mask 15 as viewed from the entrance surface 201 side. Fig. 4 is a plan view illustrating an example of the framed mask 15 as viewed from the exit surface 202 side. Fig. 5A is a cross-sectional view of the framed mask 15 in Fig. 3 taken along line V-V. Fig. 5B is an enlarged view of a portion enclosed by the two-dot chain line in the cross section of Fig. 5A.

First, the mask 20 will be described in detail. As illustrated in Fig. 5A, the mask 20 includes a first layer 30 and a second layer 40 arranged in this order from the entrance surface 201 toward the exit surface 202. The first layer 30 contains, for example, silicon, a silicon compound, glass, or aluminum oxide (Al₂O₃). The silicon compound is, for example, silicon carbide (SiC). As illustrated in Fig. 5A, the mask 20 may further include an intermediate layer 50. The intermediate layer 50 is disposed between the first layer 30 and the second layer 40. Hereinafter, each layer will be described.

As well illustrated in Fig. 5B, the first layer 30 includes a first surface 301, a second surface 302, a first opening 31, and a first wall surface 32. The first surface 301 may constitute the entrance surface 201. The second surface 302 is located on the opposite side of the first layer 30 from the first surface 301.

The first opening 31 penetrates the first layer 30 from the first surface 301 to the second surface 302. As illustrated in Fig. 3, the first layer 30 may include a plurality of first openings 31. The plurality of first openings 31 may be arranged in a first direction D1 and a second direction D2. The second direction D2 may be orthogonal to the first direction D1.

Each first opening 31 may correspond to one screen of an organic EL display device. The mask 20 illustrated in Fig. 3 can simultaneously form patterns of the organic layers corresponding to a plurality of screens on the substrate 110. As illustrated in Fig. 3, each of the first openings 31 may have a rectangular outline in plan view.

The first wall surface 32 is a surface of the first layer 30 facing the first opening 31. In the example illustrated in Fig. 3, the first wall surface 32 extends in the normal direction of the first surface 301.

As illustrated in Fig. 3, a region of the first layer 30 where the first openings 31 are not formed may include an outer region 35 and an inner region 36. The inner region 36 is a region located between two first openings 31 that are adjacent to each other in plan view. The outer region 35 is a region located between an outer edge 303 of the first layer 30 and the first openings 31 in plan view. As illustrated in Fig. 3, the inner region 36 may extend in the first direction D1 and the second direction D2. The outer region 35 includes a connection region 37 to which the frame 60 is connected.

As illustrated in Fig. 4, the first layer 30 may include one or more alignment marks 39. The one or more alignment marks 39 are formed, for example, on the first surface 301. The one or more alignment marks 39 are used, for example, to adjust the relative position of the frame 60 with respect to the mask 20. When the frame 60 has a property of transmitting visible light, the alignment marks 39 can be visually recognized through the frame 60.

As illustrated in Fig. 4, each of the alignment marks 39 may have a circular outline in plan view. Although not illustrated, the alignment marks 39 may have an outline other than a circular shape, such as a rectangular shape or a cross shape. The one or more alignment marks 39 may be located in the outer region 35.

In the case where the first layer 30 contains silicon or a silicon compound, the first layer 30 may be fabricated by processing a silicon wafer, for example. As illustrated in Fig. 3, the outer edge 303 of the first layer 30 may include a straight portion. The straight portion is also referred to as an orientation flat. Although not illustrated, a cutout may be formed in the outer edge 303. The cutout is also referred to as a notch. When the first layer 30 is fabricated by processing a silicon wafer, the orientation flat and the notch represent the crystal orientation of the silicon wafer.

A maximum dimension S1 of the first layer 30 in plan view may be, for example, 100 mm or more, 150 mm or more, or 200 mm or more. The dimension S1 may be, for example, 300 mm or less, 400 mm or less, or 500 mm or less. The range of the dimension S1 may be defined by a first group consisting of 100 mm, 150 mm, and 200 mm and/or a second group consisting of 300 mm, 400 mm, and 500 mm. The range of the dimension S1 may be defined by a combination of any one of the values included in the first group described above and any one of the values included in the second group described above. The range of the dimension S1 may be defined by a combination of any two of the values included in the first group described above. The range of the dimension S1 may be defined by a combination of any two of the values included in the second group described above. The dimension S1 may be, for example, 100 mm or more and 500 mm or less, 100 mm or more and 400 mm or less, 100 mm or more and 300 mm or less, 100 mm or more and 200 mm or less, 100 mm or more and 150 mm or less, 150 mm or more and 500 mm or less, 150 mm or more and 400 mm or less, 150 mm or more and 300 mm or less, 150 mm or more and 200 mm or less, 200 mm or more and 500 mm or less, 200 mm or more and 400 mm or less, 200 mm or more and 300 mm or less, 300 mm or more and 500 mm or less, 300 mm or more and 400 mm or less, or 400 mm or more and 500 mm or less.

A dimension S2 of each first opening 31 in a direction in which the first openings 31 are arranged may be, for example, 3 mm or more, 10 mm or more, or 20 mm or more. The dimension S2 may be, for example, 30 mm or less, 50 mm or less, or 100 mm or less. The range of the dimension S2 may be defined by a first group consisting of 3 mm, 10 mm, and 20 mm and/or a second group consisting of 30 mm, 50 mm, and 100 mm. The range of the dimension S2 may be defined by a combination of any one of the values included in the first group described above and any one of the values included in the second group described above. The range of the dimension S2 may be defined by a combination of any two of the values included in the first group described above. The range of the dimension S2 may be defined by a combination of any two of the values included in the second group described above. The dimension S2 may be, for example, 3 mm or more and 100 mm or less, 3 mm or more and 50 mm or less, 3 mm or more and 30 mm or less, 3 mm or more and 20 mm or less, 3 mm or more and 10 mm or less, 10 mm or more and 100 mm or less, 10 mm or more and 50 mm or less, 10 mm or more and 30 mm or less, 10 mm or more and 20 mm or less, 20 mm or more and 100 mm or less, 20 mm or more and 50 mm or less, 20 mm or more and 30 mm or less, 30 mm or more and 100 mm or less, 30 mm or more and 50 mm or less, or 50 mm or more and 100 mm or less.

A spacing S3 between two first adjacent openings 31 in the direction in which the first openings 31 are arranged may be, for example, 0.1 mm or more, 0.5 mm or more, or 1.0 mm or more. The spacing S3 may be, for example, 10 mm or less, 15 mm or less, or 20 mm or less. The range of the spacing S3 may be defined by a first group consisting of 0.1 mm, 0.5 mm, and 1.0 mm and/or a second group consisting of 10 mm, 15 mm, and 20 mm. The range of the spacing S3 may be defined by a combination of any one of the values included in the first group described above and any one of the values included in the second group described above. The range of the spacing S3 may be defined by a combination of any two of the values included in the first group described above. The range of the spacing S3 may be defined by a combination of any two of the values included in the second group described above. The spacing S3 may be, for example, 0.1 mm or more and 20 mm or less, 0.1 mm or more and 15 mm or less, 0.1 mm or more and 10 mm or less, 0.1 mm or more and 1.0 mm or less, 0.1 mm or more and 0.5 mm or less, 0.5 mm or more and 20 mm or less, 0.5 mm or more and 15 mm or less, 0.5 mm or more and 10 mm or less, 0.5 mm or more and 1.0 mm or less, 1.0 mm or more and 20 mm or less, 1.0 mm or more and 15 mm or less, 1.0 mm or more and 10 mm or less, 10 mm or more and 20 mm or less, 10 mm or more and 15 mm or less, or 15 mm or more and 20 mm or less.

The thickness of the first layer 30 is defined as a maximum thickness T1 of the outer region 35. The thickness T1 may be, for example, 50 µm or more, 100 µm or more, or 200 µm or more. The thickness T1 may be, for example, 600 µm or less, 800 µm or less, or 1000 µm or less. The range of the thickness T1 may be defined by a first group consisting of 50 µm, 100 µm, and 200 µm and/or a second group consisting of 600 µm, 800 µm, and 1000 µm. The range of the thickness T1 may be defined by a combination of any one of the values included in the first group described above and any one of the values included in the second group described above. The range of the thickness T1 may be defined by a combination of any two of the values included in the first group described above. The range of the thickness T1 may be defined by a combination of any two of the values included in the second group described above. The thickness T1 may be, for example, 50 µm or more and 1000 µm or less, 50 µm or more and 800 µm or less, 50 µm or more and 600 µm or less, 50 µm or more and 200 µm or less, 50 µm or more and 100 µm or less, 100 µm or more and 1000 µm or less, 100 µm or more and 800 µm or less, 100 µm or more and 600 µm or less, 100 µm or more and 200 µm or less, 200 µm or more and 1000 µm or less, 200 µm or more and 800 µm or less, 200 µm or more and 600 µm or less, 600 µm or more and 1000 µm or less, 600 µm or more and 800 µm or less, or 800 µm or more and 1000 µm or less.

Next, the second layer 40 will be described. The second layer 40 includes a third surface 401, a fourth surface 402, and a plurality of second openings 41. The third surface 401 faces toward the second surface 302 of the first layer 30. The fourth surface 402 is located on the opposite side of the second layer 40 from the third surface 401.

The second openings 41 penetrate through the second layer 40 from the third surface 401 to the fourth surface 402. One second opening 41 corresponds to one organic layer 130. One group of a plurality of regularly arranged second openings 41 corresponds to one screen of the organic EL display device. As illustrated in Figs. 3 and 4, one group of a plurality of regularly arranged second openings 41 may overlap one first opening 31 in plan view. A plurality of groups of the second openings 41 are supported by the first layer 30 formed by processing a single member such as a silicon wafer.

The second layer 40 may include a peripheral region 43 and an effective region 44. The peripheral region 43 is a region that overlaps the first layer 30 in plan view. The effective region 44 is a region in which one group of a plurality of regularly arranged second openings 41 is distributed. The peripheral region 43 may include an outer region 45 and an inner region 46. The outer region 45 is a region that overlaps the outer region 35 of the first layer 30 in plan view. The inner region 46 is a region that overlaps the inner region 36 of the first layer 30 in plan view.

The thickness of the second layer 40 is smaller than the thickness T1 of the first layer 30. The thickness of the second layer 40 may be, for example, 0.5 µm or more, 1.0 µm or more, or 2.0 µm or more. The thickness of the second layer 40 may be, for example, 5 µm or less, 10 µm or less, or 25 µm or less. The range of the thickness of the second layer 40 may be defined by a first group consisting of 0.5 µm, 1.0 µm, and 2.0 µm and/or a second group consisting of 5 µm, 10 µm, and 25 µm. The range of the thickness of the second layer 40 may be defined by a combination of any one of the values included in the first group described above and any one of the values included in the second group described above. The range of the thickness of the second layer 40 may be defined by a combination of any two of the values included in the first group described above. The range of the thickness of the second layer 40 may be defined by a combination of any two of the values included in the second group described above. The thickness of the second layer 40 may be, for example, 0.5 µm or more and 25 µm or less, 0.5 µm or more and 10 µm or less, 0.5 µm or more and 5 µm or less, 0.5 µm or more and 2.0 µm or less, 0.5 µm or more and 1.0 µm or less, 1.0 µm or more and 25 µm or less, 1.0 µm or more and 10 µm or less, 1.0 µm or more and 5 µm or less, 1.0 µm or more and 2.0 µm or less, 2.0 µm or more and 25 µm or less, 2.0 µm or more and 10 µm or less, 2.0 µm or more and 5 µm or less, 5 µm or more and 25 µm or less, 5 µm or more and 10 µm or less, or 10 µm or more and 25 µm or less. Occurrence of a shadow can be suppressed when the thickness of the second layer 40 is 25 µm or less. Occurrence of, for example, defects such as pinholes and deformation in the second layer 40 can be suppressed when the thickness of the second layer 40 is 0.5 µm or more.

A dimension S4 of each of the second openings 41 in plan view may be, for example, 1 µm or more, 2 µm or more, or 3 µm or more. The dimension S4 may be, for example, 5 µm or less, 10 µm or less, or 25 µm or less. The range of the dimension S4 may be defined by a first group consisting of 1 µm, 2 µm, and 3 µm and/or a second group consisting of 5 µm, 10 µm, and 25 µm. The range of the dimension S4 may be defined by a combination of any one of the values included in the first group described above and any one of the values included in the second group described above. The range of the dimension S4 may be defined by a combination of any two of the values included in the first group described above. The range of the dimension S4 may be defined by a combination of any two of the values included in the second group described above. The dimension S4 may be, for example, 1 µm or more and 25 µm or less, 1 µm or more and 10 µm or less, 1 µm or more and 5 µm or less, 1 µm or more and 3 µm or less, 1 µm or more and 2 µm or less, 2 µm or more and 25 µm or less, 2 µm or more and 10 µm or less, 2 µm or more and 5 µm or less, 2 µm or more and 3 µm or less, 3 µm or more and 25 µm or less, 3 µm or more and 10 µm or less, 3 µm or more and 5 µm or less, 5 µm or more and 25 µm or less, 5 µm or more and 10 µm or less, or 10 µm or more and 25 µm or less.

A spacing S5 between two adjacent second openings 41 in a direction in which the second openings 41 are arranged may be, for example, 1 µm or more, 2 µm or more, or 3 µm or more. The spacing S5 may be, for example, 5 µm or less, 10 µm or less, or 25 µm or less. The range of the spacing S5 may be defined by a first group consisting of 1 µm, 2 µm, and 3 µm and/or a second group consisting of 5 µm, 10 µm, and 25 µm. The range of the spacing S5 may be defined by a combination of any one of the values included in the first group described above and any one of the values included in the second group described above. The range of the spacing S5 may be defined by a combination of any two of the values included in the first group described above. The range of the spacing S5 may be defined by a combination of any two of the values included in the second group described above. The spacing S5 may be, for example, 1 µm or more and 25 µm or less, 1 µm or more and 10 µm or less, 1 µm or more and 5 µm or less, 1 µm or more and 3 µm or less, 1 µm or more and 2 µm or less, 2 µm or more and 25 µm or less, 2 µm or more and 10 µm or less, 2 µm or more and 5 µm or less, 2 µm or more and 3 µm or less, 3 µm or more and 25 µm or less, 3 µm or more and 10 µm or less, 3 µm or more and 5 µm or less, 5 µm or more and 25 µm or less, 5 µm or more and 10 µm or less, or 10 µm or more and 25 µm or less.

Next, the intermediate layer 50 will be described. The intermediate layer 50 includes a layer that performs a certain function with respect to the first layer 30 or the second layer 40. For example, the intermediate layer 50 may function as a stopper layer that stops etching in a step of processing the first layer 30 by etching. When the intermediate layer 50 is a stopper layer, the intermediate layer 50 may contain aluminum, an aluminum alloy, titanium, or a titanium alloy. When the intermediate layer 50 is a stopper layer, the intermediate layer 50 may contain an inorganic compound such as silicon oxide. Alternatively, the intermediate layer 50 may function to bond the first layer 30 and the second layer 40. For example, the intermediate layer 50 may be a bonding layer containing an adhesive.

The thickness of the intermediate layer 50 is not particularly limited as long as the above-described function can be exhibited. For example, the thickness of the intermediate layer 50 may be smaller than the thickness of the second layer 40 or may be equal to or larger than the thickness of the second layer 40. The thickness of the intermediate layer 50 may be, for example, 5 nm or more, 50 nm or more, or 75 nm or more. The thickness of the intermediate layer 50 may be, for example, 1 µm or less, 10 µm or less, or 100 µm or less. The range of the thickness of the intermediate layer 50 may be defined by a first group consisting of 5 nm, 50 nm, and 75 nm and/or a second group consisting of 1 µm, 10 µm, and 100 µm. The range of the thickness of the intermediate layer 50 may be defined by a combination of any one of the values included in the first group described above and any one of the values included in the second group described above. The range of the thickness of the intermediate layer 50 may be defined by a combination of any two of the values included in the first group described above. The range of the thickness of the intermediate layer 50 may be defined by a combination of any two of the values included in the second group described above. The thickness of the intermediate layer 50 may be, for example, 5 nm or more and 100 µm or less, 5 nm or more and 10 µm or less, 5 nm or more and 1 µm or less, 5 nm or more and 75 nm or less, 5 nm or more and 50 nm or less, 50 nm or more and 100 µm or less, 50 nm or more and 10 µm or less, 50 nm or more and 1 µm or less, 50 nm or more and 75 nm or less, 75 nm or more and 100 µm or less, 75 nm or more and 10 µm or less, 75 nm or more and 1 µm or less, 1 µm or more and 100 µm or less, 1 µm or more and 10 µm or less, or 10 µm or more and 100 µm or less.

Preferably, the intermediate layer 50 is positioned so as not to overlap the second openings 41 in plan view. This makes it possible to suppress the occurrence of shadows caused by the intermediate layer 50.

In the mask 20 described above, a region including the region where the first openings 31 are formed, the region where the second openings 41 are formed (the effective region 44), and the inner regions 36 and 46 is hereinafter also referred to as an inner region 26 of the mask 20. A region including the outer regions 35 and 45 is also referred to as an outer region 25 of the mask 20. The outer region 25 surrounds the inner region 26.

Next, the frame 60 will be described in detail. The frame 60 is attached to the mask 20 for the purpose of being gripped when the mask 20 is handled, for example, when the mask 20 is moved. As illustrated in, for example, Fig. 3, the second openings 41, and thus the first openings 31, are formed in the mask 20 up to the vicinity of the outer edge of the mask 20. In general, when the mask 20 is handled, for example, when the mask 20 is moved, it is desirable to grip the outer region 35 of the first layer 30 to prevent, for example, deformation of the second openings 41 of the second layer 40 or to prevent contamination of the second layer 40. However, since the first openings 31 are formed up to the vicinity of the outer edge 303 of the first layer 30, the area of the outer region 35 is insufficient to grip the outer region 35. In addition, since the first openings 31 are formed up to the vicinity of the outer edge 303 of the first layer 30, the outer region 35 is narrow. The narrow outer region 35 is likely to be damaged. The outer region 35 is particularly likely to be damaged when the first layer 30 contains silicon or a silicon compound. By providing the frame 60 on the outer region 25 of such a mask 20, the frame 60 can be gripped during handling of the mask 20, and the possibility of damage to the first layer 30 is reduced. As a result, handling of the mask 20 is facilitated.

As understood from Figs. 3 to 5B, the frame 60 includes a fifth surface 601 and a sixth surface 602. The fifth surface 601 faces in the same direction as the fourth surface 402. The sixth surface 602 is located on the opposite side of the frame 60 from the fifth surface 601. In the illustrated example, the fifth surface 601 faces toward the first surface 301.

As illustrated in Figs. 5A and 5B, the frame 60 is connected to the first surface 301 of the outer region 35 of the first layer 30. In the illustrated example, a connection layer 70 is disposed between the first surface 301 of the outer region 35 and the fifth surface 601 of the frame 60. The frame 60 is connected to the first layer 30 via the connection layer 70. In plan view, the frame 60 does not overlap the first openings 31. In plan view, at least a part of the frame 60 extends to the outside of the outer edge 303 of the first layer 30. Thus, the frame 60 provides an extended region for gripping when the mask 20 is handled.

The frame 60 contains a glass material or a metal material. The glass material is quartz glass, borosilicate glass, alkali-free glass, soda glass, or the like. The metal material is an invar material or stainless steel such as SUS430 or SUS304. When the frame 60 contains these materials, the rigidity of the frame 60 can be made greater than that of the first layer 30. The material of the frame 60 may be determined such that the frame 60 has required rigidity, in consideration of a gripping force of an operator or a robot hand that handles the framed mask 15.

The coefficient of linear thermal expansion of the frame 60 is preferably substantially the same as the coefficient of linear thermal expansion of the first layer 30. In this case, when the framed mask 15 is heated, the elongation rates of the frame 60 and the first layer 30 can be made substantially the same. As a result, the possibility of damage to the first layer 30 is suppressed. Specifically, the absolute value of the difference between the coefficient of linear thermal expansion of the frame 60 and the coefficient of linear thermal expansion of the first layer 30 is 15 ppm/°C or less, and may be 10 ppm/°C or less, or 5.0 ppm/°C or less.

In the illustrated example, the frame 60 is formed in an annular shape. The frame 60 has a region extending circumferentially outside the outer edge 303 of the first layer 30 in plan view. Therefore, the possibility that the outer region 35 of the first layer 30 is damaged when the mask 20 is handled is effectively suppressed. More specifically, the frame 60 has, at its center, a third opening 61 penetrating from the fifth surface 601 to the sixth surface 602. In the illustrated example, the third opening 61 has a shape similar to that of the outer edge 303 of the first layer 30. A maximum dimension S9 of the third opening 61 is smaller than the maximum dimension S1 of the outer edge 303 of the first layer 30. In plan view, the third opening 61 overlaps the inner region 26 of the mask 20.

The shape and dimension of an outer edge 603 of the frame 60 are not particularly limited. The shape and dimension S10 of the outer edge 603 of the frame 60 may be determined in consideration of the dimensions and shape of the hand of the operator or the robot hand that handles the framed mask 15, and the dimensions and shape of the mask holder 9 of the vapor deposition apparatus 10. The outer edge 603 of the frame 60 may have a quadrangular shape or another polygonal shape. The dimension S10 of the outer edge 603 of the frame 60 may be, for example, 100 mm or more, 150 mm or more, or 200 mm or more. The dimension S10 may be, for example, 300 mm or less, 400 mm or less, or 500 mm or less. The range of the dimension S10 may be defined by a first group consisting of 100 mm, 150 mm, and 200 mm and/or a second group consisting of 300 mm, 400 mm, and 500 mm. The range of the dimension S10 may be defined by a combination of any one of the values included in the first group described above and any one of the values included in the second group described above. The range of the dimension S10 may be defined by a combination of any two of the values included in the first group described above. The range of the dimension S10 may be defined by a combination of any two of the values included in the second group described above. The dimension S10 may be, for example, 100 mm or more and 500 mm or less, 100 mm or more and 400 mm or less, 100 mm or more and 300 mm or less, 100 mm or more and 200 mm or less, 100 mm or more and 150 mm or less, 150 mm or more and 500 mm or less, 150 mm or more and 400 mm or less, 150 mm or more and 300 mm or less, 150 mm or more and 200 mm or less, 200 mm or more and 500 mm or less, 200 mm or more and 400 mm or less, 200 mm or more and 300 mm or less, 300 mm or more and 500 mm or less, 300 mm or more and 400 mm or less, or 400 mm or more and 500 mm or less.

A distance S11 between the outer edge 603 of the frame 60 and the outer edge 303 of the first layer 30 may also be determined in consideration of the dimensions and shape of the hand of the operator or the robot hand that handles the framed mask 15, and the dimensions and shape of the mask holder 9 of the vapor deposition apparatus 10. The distance S11 may be, for example, 5 mm or more, 10 mm or more, or 15 mm or more. The distance S11 may be, for example, 30 mm or less, 60 mm or less, or 100 mm or less. The range of the distance S11 may be defined by a first group consisting of 5 mm, 10 mm, and 15 mm and/or a second group consisting of 30 mm, 60 mm, and 100 mm. The range of the distance S11 may be defined by a combination of any one of the values included in the first group described above and any one of the values included in the second group described above. The range of the distance S11 may be defined by a combination of any two of the values included in the first group described above. The range of the distance S11 may be defined by a combination of any two of the values included in the second group described above. The distance S11 may be, for example, 5 mm or more and 100 mm or less, 5 mm or more and 60 mm or less, 5 mm or more and 30 mm or less, 5 mm or more and 15 mm or less, 5 mm or more and 10 mm or less, 10 mm or more and 100 mm or less, 10 mm or more and 60 mm or less, 10 mm or more and 30 mm or less, 10 mm or more and 15 mm or less, 15 mm or more and 100 mm or less, 15 mm or more and 60 mm or less, 15 mm or more and 30 mm or less, 30 mm or more and 100 mm or less, 30 mm or more and 60 mm or less, or 60 mm or more and 100 mm or less.

As illustrated in Fig. 5B, the frame 60 includes, around the third opening 61, a connection region 67 to which the mask 20 is connected. The connection region 67 overlaps the connection region 37 of the first layer 30 in plan view. A width S12 of the connection regions 37 and 67 may be determined in consideration of, for example, the bonding strength between the mask 20 and the frame 60. The width S12 may be, for example, 1 mm or more, 5 mm or more, or 10 mm or more. The width S12 may be, for example, 20 mm or less, 25 mm or less, or 30 mm or less. The range of the width S12 may be defined by a first group consisting of 1 mm, 5 mm, and 10 mm and/or a second group consisting of 20 mm, 25 mm, and 30 mm. The range of the width S12 may be defined by a combination of any one of the values included in the first group described above and any one of the values included in the second group described above. The range of the width S12 may be defined by a combination of any two of the values included in the first group described above. The range of the width S12 may be defined by a combination of any two of the values included in the second group described above. The width S12 may be, for example, 1 mm or more and 30 mm or less, 1 mm or more and 25 mm or less, 1 mm or more and 20 mm or less, 1 mm or more and 10 mm or less, 1 mm or more and 5 mm or less, 5 mm or more and 30 mm or less, 5 mm or more and 25 mm or less, 5 mm or more and 20 mm or less, 5 mm or more and 10 mm or less, 10 mm or more and 30 mm or less, 10 mm or more and 25 mm or less, 10 mm or more and 20 mm or less, 20 mm or more and 30 mm or less, 20 mm or more and 25 mm or less, or 25 mm or more and 30 mm or less.

A thickness T2 of the frame 60 is also not particularly limited. The thickness T2 may also be determined in consideration of the dimensions and shape of the hand of the operator or the robot hand that handles the framed mask 15, and the dimensions and shape of the mask holder 9 of the vapor deposition apparatus 10. The thickness T2 may be, for example, 500 µm or more, 2 mm or more, or 5 mm or more. The thickness T2 may be, for example, 10 mm or less, 20 mm or less, or 30 mm or less. The range of the thickness T2 may be defined by a first group consisting of 500 µm, 2 mm, and 5 mm and/or a second group consisting of 10 mm, 20 mm, and 30 mm. The range of the thickness T2 may be defined by a combination of any one of the values included in the first group described above and any one of the values included in the second group described above. The range of the thickness T2 may be defined by a combination of any two of the values included in the first group described above. The range of the thickness T2 may be defined by a combination of any two of the values included in the second group described above. The thickness T2 may be, for example, 500 µm or more and 30 mm or less, 500 µm or more and 20 mm or less, 500 µm or more and 10 mm or less, 500 µm or more and 5 mm or less, 500 µm or more and 2 mm or less, 2 mm or more and 30 mm or less, 2 mm or more and 20 mm or less, 2 mm or more and 10 mm or less, 2 mm or more and 5 mm or less, 5 mm or more and 30 mm or less, 5 mm or more and 20 mm or less, 5 mm or more and 10 mm or less, 10 mm or more and 30 mm or less, 10 mm or more and 20 mm or less, or 20 mm or more and 30 mm or less.

By determining the shape and dimension of the outer edge 603 of the frame 60 and the thickness T2 of the frame 60 in consideration of the dimensions and shape of the robot hand that handles the framed mask 15 and/or the dimensions and shape of the mask holder 9 of the vapor deposition apparatus 10, the shape and dimensions of the framed mask 15 can be made suitable for the existing robot hand and/or the existing vapor deposition apparatus 10. In other words, it is not necessary to adapt the shape and dimensions of the mask 20 to the shape and dimensions of the existing robot hand and/or the existing vapor deposition apparatus 10, allowing the mask 20 to be designed with greater flexibility.

In the illustrated example, the fifth surface 601 of the frame 60 is located on the side where the first surface 301 of the first layer 30 is positioned, as viewed from the position of the fourth surface 402 of the second layer 40. In other words, the second layer 40 protrudes from the fifth surface 601 of the frame 60. Therefore, when forming a vapor deposition layer on the substrate 110 or on a component on the substrate 110 through the mask 20, the second layer 40 can be brought into contact with the substrate 110 or the component on the substrate 110.

As illustrated in Fig. 3, the frame 60 may include one or more alignment marks 69. This makes it easier to position the mask 20 relative to the frame 60 when attaching the frame 60 to the mask 20. For example, the position of the frame 60 relative to the mask 20 can be adjusted by observing the one or more alignment marks 69 of the frame 60 and the one or more alignment marks 39 of the mask 20.

As illustrated in Figs. 5A and 5B, the frame 60 is connected to the first layer 30 via the connection layer 70. The connection layer 70 fixes the frame 60 to the first layer 30 by adhesion, bonding, or welding. The connection layer 70 may contain a glass material, an inorganic material, a metal material, or a resin material. The connection layer 70 may be formed of a glass frit, a glass paste, a solder paste, a conductive paste, an epoxy resin, a polyimide, an acrylic resin, or the like. The connection layer 70 may be formed of an ultraviolet-curable adhesive, a thermosetting adhesive, or the like. Examples of the ultraviolet-curable adhesive include an ultraviolet-curable epoxy resin "XNR5516Z-B1" manufactured by Nagase ChemteX Corporation. Examples of the thermosetting adhesive include NK Ester "BEP-500" manufactured by Shin-Nakamura Chemical Co., Ltd. and "ASF400" manufactured by NIPPON STEEL Chemical & Material Co., Ltd. Further, for the purpose of suppressing the generation of outgas from the connection layer 70 during the vapor deposition process in the vapor deposition apparatus 10, for example, a highly heat-resistant epoxy adhesive "Aremco-Bond 526N" manufactured by Aremco Products Inc. or a UV-curable adhesive "WORLD ROCK (registered trademark) 5910 (product number)" or "WORLD ROCK (registered trademark) 8723K9B (product number)" manufactured by Kyoritsu Chemical & Co., Ltd. can be employed as the material for forming the connection layer 70. Further, by using a material having high solvent resistance to form the connection layer 70, it is possible to suppress the risk that, when the framed mask 15 used in the vapor deposition process is cleaned to remove the vapor deposition material, the connection layer 70 is deformed upon contact with a cleaning liquid and the frame 60 is separated from the mask 20. Examples of materials having high solvent resistance that may be used to form the connection layer 70 include an ultraviolet curable adhesive "ThreeBond (registered trademark) 3026E (product name)" manufactured by ThreeBond Holdings Co., Ltd. Further, by employing a material that is separable from the frame 60 and/or the mask 20 to form the connection layer 70, the frame 60 and the mask 20 can be reused. Examples of materials that are separable from the frame 60 and the mask 20 but suitable for forming the connection layer 70 include a double-sided peelable adhesive "BBX100 (product name)" manufactured by Cemedine Co., Ltd.; a visible-light-curable adhesive "Clear Prest (registered trademark) CP4374 (product name)" or "Clear Prest (registered trademark) K40 (product name)" manufactured by Sekisui Fuller Company, Ltd.; and a cyanoacrylate-based instantaneous adhesive "Skylock (registered trademark) R-4" manufactured by Nikka Seiko Co., Ltd.

The thickness of the connection layer 70 may be, for example, 0.05 µm or more, 5 µm or more, or 10 µm or more. The thickness of the connection layer 70 may be, for example, 20 µm or less, 50 µm or less, or 100 µm or less. The range of the thickness of the connection layer 70 may be defined by a first group consisting of 0.05 µm, 5 µm, and 10 µm and/or a second group consisting of 20 µm, 50 µm, and 100 µm. The range of the thickness of the connection layer 70 may be defined by a combination of any one of the values included in the first group described above and any one of the values included in the second group described above. The range of the thickness of the connection layer 70 may be defined by a combination of any two of the values included in the first group described above. The range of the thickness of the connection layer 70 may be defined by a combination of any two of the values included in the second group described above. The thickness of the connection layer 70 may be, for example, 0.05 µm or more and 100 µm or less, 0.05 µm or more and 50 µm or less, 0.05 µm or more and 20 µm or less, 0.05 µm or more and 10 µm or less, 0.05 µm or more and 5 µm or less, 5 µm or more and 100 µm or less, 5 µm or more and 50 µm or less, 5 µm or more and 20 µm or less, 5 µm or more and 10 µm or less, 10 µm or more and 100 µm or less, 10 µm or more and 50 µm or less, 10 µm or more and 20 µm or less, 20 µm or more and 100 µm or less, 20 µm or more and 50 µm or less, or 50 µm or more and 100 µm or less.

As illustrated in Fig. 4, the framed mask 15 may further include one or more alignment marks 16. The one or more alignment marks 16 are formed, for example, on the exit surface 202 of the mask 20. The one or more alignment marks 16 are used to adjust the relative position of the framed mask 15 with respect to the substrate 110. That is, the one or more alignment marks 16 are used to adjust the relative position of the mask 20 with respect to the substrate 110. When the substrate 110 has a property of transmitting visible light, the one or more alignment marks 16 can be visually recognized through the substrate 110. The one or more alignment marks 16 may be formed in the second layer 40 or in a layer other than the second layer 40. The one or more alignment marks 16 may be located in the outer region 25 of the mask 20 or in the inner region 26 of the mask 20.

The thicknesses of the respective layers, the dimensions and spacing of the components, and the like can be measured by observing an image of a cross section of the mask 20 using a scanning electron microscope.

### (Connection apparatus)

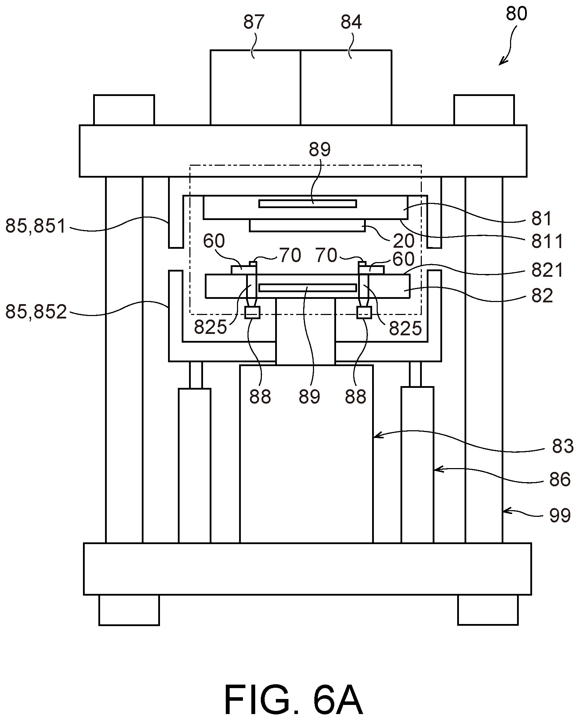

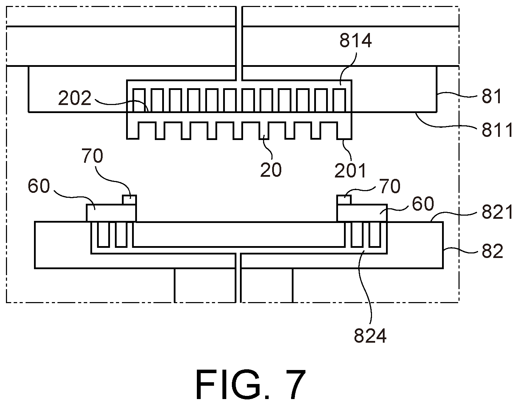

Next, a connection apparatus 80 according to the present embodiment will be described with reference to Figs. 6A to 9. The connection apparatus 80 is used to connect the mask 20 to the frame 60. Figs. 6A to 6E are cross-sectional views of the connection apparatus 80. Fig. 7 is an enlarged view of a portion enclosed by the two-dot chain line in Fig. 6A. In Fig. 7, heaters 89, alignment cameras 88, and alignment openings 825, which will be described later, are not illustrated.

In the example illustrated in Figs. 6A to 6E, the connection apparatus 80 includes a first pressing plate 81, a second pressing plate 82, a pressing device 83, and a suction device 84. The first pressing plate 81 and the second pressing plate 82 face toward each other. In the illustrated example, the first pressing plate 81 is disposed above the second pressing plate 82. The pressing device 83 is configured to press the first pressing plate 81 and the second pressing plate 82 against each other. The connection apparatus 80 may further include a chamber 85, an opening/closing device 86, a pressure reducing device 87, and one or more alignment cameras 88. The chamber 85 accommodates the first pressing plate 81 and the second pressing plate 82. The opening/closing device 86 is configured to open and close the chamber 85. The pressure reducing device 87 is configured to reduce the pressure in the chamber 85. The connection apparatus 80 may further include a support body 99 that supports the pressing plates 81 and 82, the pressing device 83, the chamber 85, the opening/closing device 86, and other components.

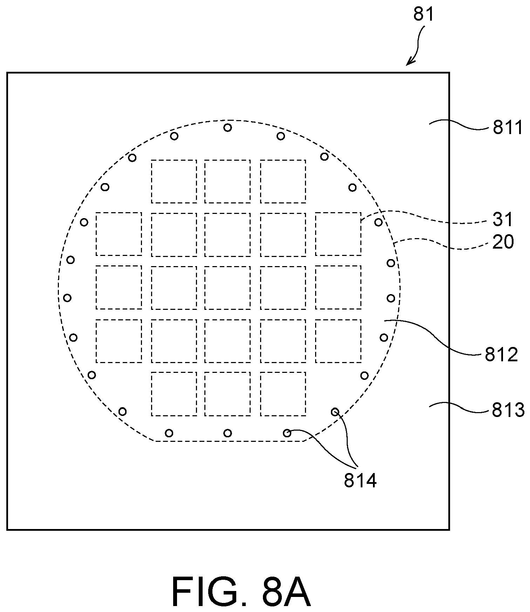

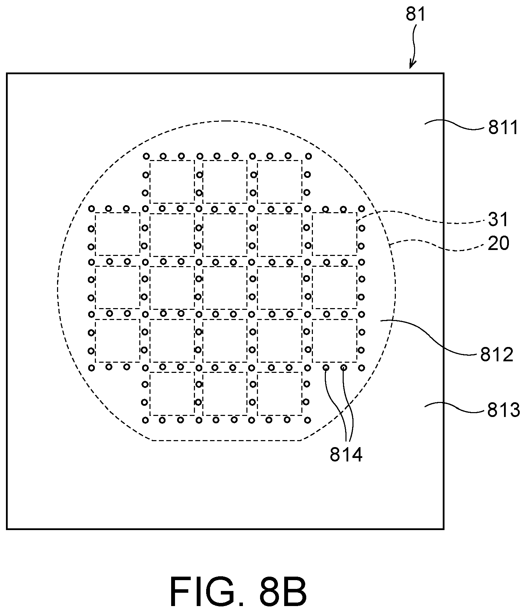

The first pressing plate 81 is configured to support the mask 20. The first pressing plate 81 has a generally flat plate shape and includes a first support surface 811 on which the mask 20 is to be placed. The mask 20 is to be placed on the first support surface 811 such that the exit surface 202 thereof faces the first support surface 811. The first support surface 811 includes an inner region 812 on which the mask 20 is to be placed, and an outer region 813 surrounding the inner region 812 (see Fig. 8A and Fig. 8B). The inner region 812 of the first support surface 811 is flat. As illustrated in Fig. 7, the first pressing plate 81 is provided with one or more first suction holes 814 that open in the first support surface 811. The one or more first suction holes 814 open in the inner region 812 of the first support surface 811. By suctioning the inside of the one or more first suction holes 814 using the suction device 84, the mask 20 can be held on the first support surface 811. The mask 20 can be held on the first pressing plate 81 by holding the mask 20 on the first support surface 811 by suction. Therefore, it is possible to suppress the risk of the mask 20 unintentionally falling from the first pressing plate 81 and being damaged. Furthermore, by attracting the mask 20 to the flat inner region 812, the exit surface 202 of the mask 20 can be made flat.

Figs. 8A and 8B are plan views illustrating the first support surface 811. In Figs. 8A and 8B, the mask 20 is indicated by dashed lines. As illustrated in Fig. 8A, the one or more first suction holes 814 may open in a region of the first support surface 811 that is to face the outer region 45 of the second layer 40. Alternatively, as illustrated in Fig. 8B, the one or more first suction holes 814 may open in a region of the first support surface 811 that is to face the peripheral region 43 of the second layer 40. Accordingly, the suction device 84 can suction the gap between the first support surface 811 and the second layer 40 through the one or more first suction holes 814, thereby enabling the exit surface 202 of the mask 20 to be attracted to the first support surface 811.

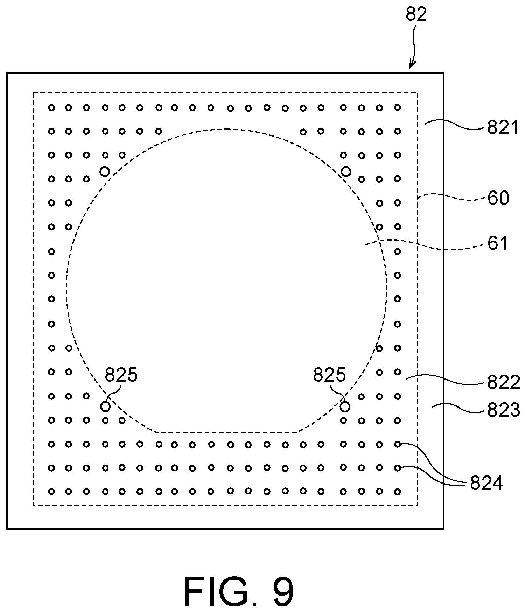

The second pressing plate 82 is configured to support the frame 60. The second pressing plate 82 has a generally flat plate shape and includes a second support surface 821 on which the frame 60 is to be placed. The frame 60 is to be placed on the second support surface 821 such that the sixth surface 602 thereof faces the second support surface 821. The second support surface 821 includes an inner region 822 on which the frame 60 is to be placed, and an outer region 823 surrounding the inner region 822 (see Fig. 9). The inner region 822 of the second support surface 821 is flat. As illustrated in Fig. 7, the second pressing plate 82 is provided with one or more second suction holes 824 that open in the second support surface 821. The one or more second suction holes 824 open in the inner region 822 of the second support surface 821. By suctioning the inside of the one or more second suction holes 824 using the suction device 84, the frame 60 can be held on the second support surface 821. The frame 60 can be held on the second pressing plate 82 by holding the frame 60 on the second support surface 821 by suction. Therefore, it is possible to suppress the risk that the frame 60 unintentionally falls from the second pressing plate 82 and is damaged. Furthermore, by holding the frame 60 on the second support surface 821 by suction, the mask 20 can be separated from the first pressing plate 81 after the mask 20 is connected to the frame 60.

Fig. 9 is a plan view illustrating the second support surface 821. In Fig. 9, the frame 60 is indicated by dashed lines. As illustrated in Fig. 9, the one or more second suction holes 824 may open in a region of the second support surface 821 that is to face the frame 60. Accordingly, the suction device 84 can suction the gap between the second support surface 821 and the frame 60 through the one or more second suction holes 824, thereby enabling the frame 60 to be held on the second support surface 821 by suction.

In the illustrated example, one or more alignment openings 825 are formed in the second pressing plate 82. The one or more alignment openings 825 penetrate through the second pressing plate 82 in the thickness direction of the second pressing plate 82. The one or more alignment openings 825 are formed at one or more positions to face the one or more alignment marks 69 of the frame 60. The one or more alignment cameras 88 are disposed so as to face toward the one or more alignment openings 825. The one or more alignment cameras 88 can capture images between the second support surface 821 and the first support surface 811 through the one or more alignment openings 825. When the frame 60 is transparent, the one or more alignment cameras 88 can be used to observe the one or more alignment marks 69 of the frame 60 disposed on the second support surface 821 and the one or more alignment marks 39 of the mask 20, thereby enabling adjustment of the position of the frame 60 relative to the mask 20.

As illustrated in Fig. 6A, one or more heaters 89 may be provided inside the first pressing plate 81 and/or the second pressing plate 82. In this case, the mask 20 and the frame 60 can be connected by heating them using the one or more heaters 89.

The first pressing plate 81 and the second pressing plate 82 are made of, for example, cast iron. In this case, the first pressing plate 81 and the second pressing plate 82 have high rigidity. Accordingly, it is possible to suppress the risk of deformation of the first pressing plate 81 and the second pressing plate 82 when the first pressing plate 81 and the second pressing plate 82 are pressed against each other. Further, the first pressing plate 81 and the second pressing plate 82 made of cast iron have high heat resistance. Accordingly, it is possible to suppress the risk of thermal deformation of the first pressing plate 81 and the second pressing plate 82 when the first pressing plate 81 and/or the second pressing plate 82 are heated by the one or more heaters 89. Of course, the material constituting the first pressing plate 81 and the second pressing plate 82 is not limited to cast iron. Other materials, such as metals other than cast iron and the like, may also be used for forming the first pressing plate 81 and the second pressing plate 82.

In the illustrated example, the first pressing plate 81 is fixed to the support body 99. The first pressing plate 81 is fixed inside a first chamber element 851, which will be described later. The second pressing plate 82 is not fixed to the support body 99. The second pressing plate 82 is disposed inside a second chamber element 852, which will be described later.

The pressing device 83 is configured to move the first pressing plate 81 and/or the second pressing plate 82 to press the first pressing plate 81 and the second pressing plate 82 against each other. By pressing the first pressing plate 81 supporting the mask 20 and the second pressing plate 82 supporting the frame 60 against each other, the mask 20 and the frame 60 are pressed against each other. In the illustrated example, the pressing device 83 is configured to move the second pressing plate 82 in a direction toward the first pressing plate 81 and in a direction away from the first pressing plate 81. The pressing device 83 may be a driving device such as an air cylinder.

By pressing the frame 60 against the mask 20 in a state where the mask 20 is held on the first pressing plate 81 by suction, the mask 20 can be connected to the frame 60 in a state where the mask 20 is flat. As a result, the flatness of the mask 20 in the framed mask 15 is improved. By pressing the mask 20 and the frame 60 against each other using the pressing plates 81 and 82, a pressing force can be uniformly applied to the connection regions 37 and 67 of the mask 20 and the frame 60. This also improves the flatness of the mask 20 in the framed mask 15.

The chamber 85 includes a first chamber element 851 and a second chamber element 852. The first chamber element 851 accommodates the first pressing plate 81. In the illustrated example, the first chamber element 851 is fixed to the support body 99 together with the first pressing plate 81. The second chamber element 852 accommodates the second pressing plate 82. The second chamber element 852 is not fixed to the support body 99.

The opening/closing device 86 is configured to move the first chamber element 851 and/or the second chamber element 852 to bring the first chamber element 851 and the second chamber element 852 into close contact with each other or separate them from each other. When the first chamber element 851 and the second chamber element 852 are in close contact with each other, the chamber 85 is closed, and a sealed space is formed inside the chamber 85. In the illustrated example, the opening/closing device 86 is configured to move the second chamber element 852 in a direction toward the first chamber element 851 and in a direction away from the first chamber element 851. The opening/closing device 86 may be a driving device such as an air cylinder.

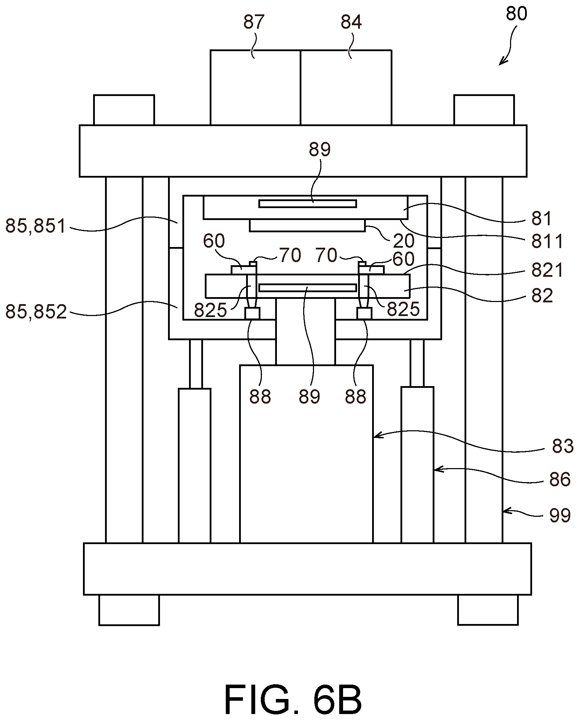

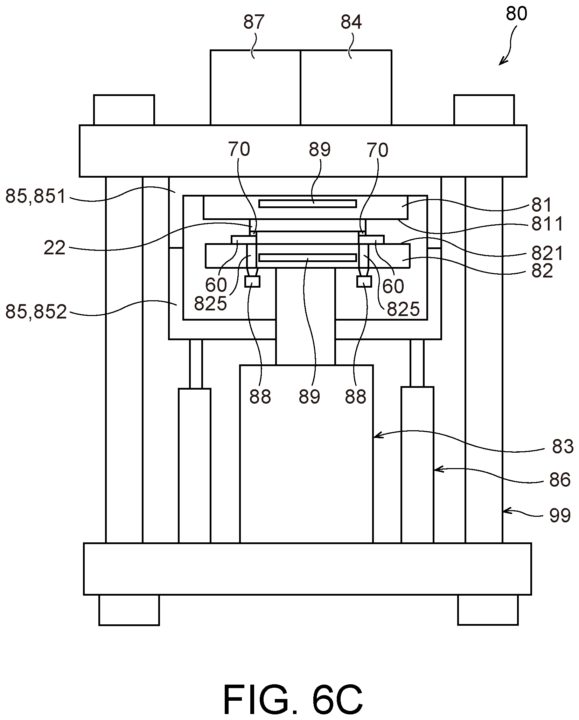

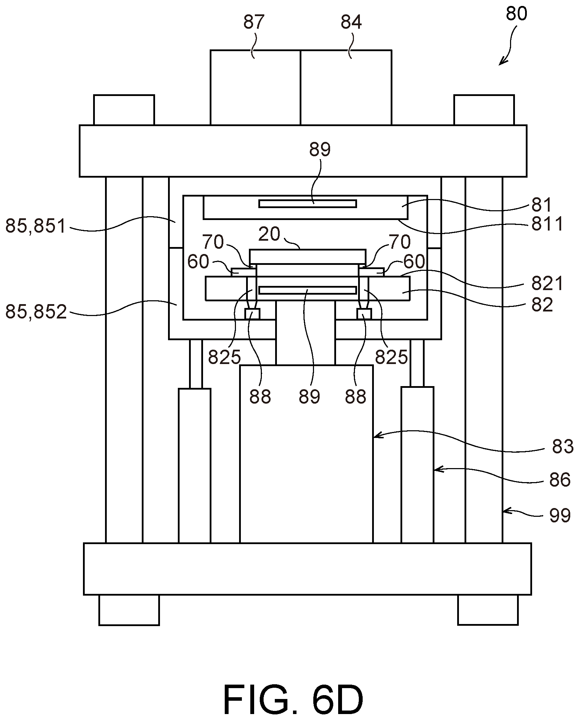

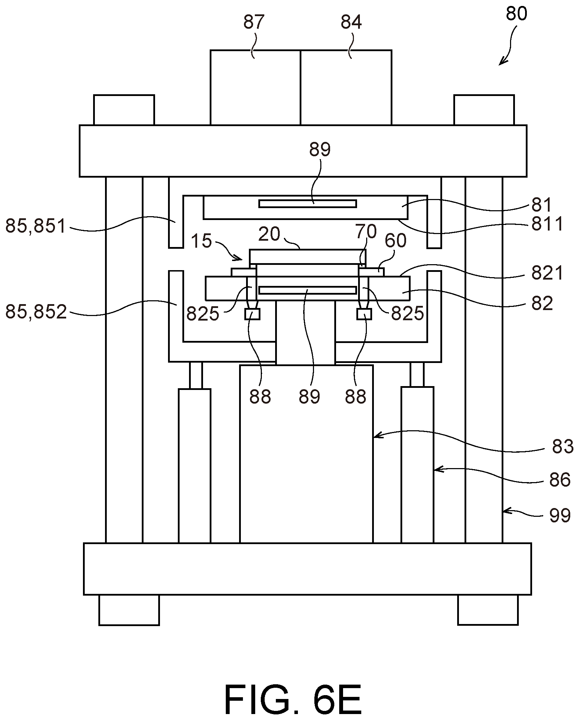

In the illustrated example, the movement of the second chamber element 852 by the opening/closing device 86 and the movement of the second pressing plate 82 by the pressing device 83 are performed independently of each other. In other words, the opening and closing of the chamber 85 by the opening/closing device 86 and the pressing of the first and second pressing plates 81 and 82 by the pressing device 83 are performed independently of each other. Therefore, as illustrated in Fig. 6B, after the opening/closing device 86 is operated to bring the second chamber element 852 into close contact with the first chamber element 851 to close the chamber 85, the pressing device 83 can be operated, as illustrated in Fig. 6C, to press the second pressing plate 82 against the first pressing plate 81. Further, as illustrated in Fig. 6D, after the pressing device 83 is operated to separate the second pressing plate 82 from the first pressing plate 81, the opening/closing device 86 can be operated, as illustrated in Fig. 6E, to separate the second chamber element 852 from the first chamber element 851 to open the chamber 85.

The pressure reducing device 87 is configured to reduce the pressure in the closed chamber 85. By connecting the mask 20 to the frame 60 in a state where the pressure in the chamber 85 is reduced, the risk that air bubbles are formed between the connection layer 70 and the mask 20 or the frame 60 is suppressed. This also improves the flatness of the mask 20 in the framed mask 15.

### (Method for connecting mask and frame)

Next, a method for connecting the mask 20 and the frame 60 according to the present embodiment will be described with reference to Figs. 6A to 6E.

First, the mask 20 and the frame 60 are prepared. The opening/closing device 86 is operated to separate the first chamber element 851 and the second chamber element 852 from each other, thereby opening the chamber 85. The pressing device 83 is operated to separate the first pressing plate 81 and the second pressing plate 82 from each other.

Next, as illustrated in Fig. 6A, the mask 20 is disposed on the first support surface 811 of the first pressing plate 81 such that the exit surface 202 and the first support surface 811 face each other. The mask 20 is disposed in the inner region 812 of the first support surface 811. Thereafter, the suction device 84 is operated to suction the inside of the one or more first suction holes 814, thereby causing the mask 20 to be attracted to the first pressing plate 81. As a result, the mask 20 is held on the first pressing plate 81. Further, when the mask 20 is held on the first pressing plate 81 by suction, the exit surface 202 of the mask 20 is brought into close contact with the flat inner region 812 of the first pressing plate 81 and becomes flat.

The frame 60 is disposed on the second support surface 821 of the second pressing plate 82 such that the sixth surface 602 and the second support surface 821 face each other. The frame 60 is disposed in the inner region 822 of the second support surface 821.

Next, the one or more alignment marks 39 of the mask 20 and the one or more alignment marks 69 of the frame 60 are observed through the one or more alignment openings 825. The alignment marks 39 and 69 are observed using the one or more alignment cameras 88. Then, the position of the frame 60 on the second pressing plate 82 is adjusted so that the alignment marks 39 overlap the corresponding alignment marks 69. Thereafter, the inside of the one or more second suction holes 824 is suctioned by the suction device 84, thereby causing the frame 60 to be attracted to the second pressing plate 82. As a result, the frame 60 is held on the second pressing plate 82.

Further, the connection layer 70 is formed in the connection region 37 of the mask 20 or in the connection region 67 of the frame 60. The connection layer 70 is formed on the first surface 301 of the first layer 30 or on the fifth surface 601 of the frame 60. The connection layer 70 may be formed before the mask 20 and/or the frame 60 are disposed on the first pressing plate 81 and/or the second pressing plate 82, or may be formed after the mask 20 and/or the frame 60 are disposed on the first pressing plate 81 and/or the second pressing plate 82.

Next, as illustrated in Fig. 6B, the opening/closing device 86 is operated to bring the second chamber element 852 into close contact with the first chamber element 851, thereby closing the chamber 85. Thereafter, the pressure reducing device 87 is operated to reduce the pressure in the chamber 85.

Next, as illustrated in Fig. 6C, the pressing device 83 is operated to press the second pressing plate 82 against the first pressing plate 81. As a result, the frame 60 is connected to the mask 20 via the connection layer 70. At this time, since the exit surface 202 of the mask 20 is held on the first pressing plate 81 by suction, the mask 20 is pressed against the frame 60 in a state where the exit surface 202 is flat. Further, a pressing force is uniformly applied to the connection regions 37 and 67 of the mask 20 and the frame 60 by the first pressing plate 81 and the second pressing plate 82. Also for this reason, the mask 20 is connected to the frame 60 in a state where the exit surface 202 is flat. Further, since the frame 60 is connected to the mask 20 in a state where the pressure in the chamber 85 is reduced, the risk that air bubbles are formed between the connection layer 70 and the mask 20 or the frame 60 is suppressed. When the second pressing plate 82 is pressed against the first pressing plate 81, the first pressing plate 81 and the second pressing plate 82 may be heated by the one or more heaters 89.

Next, the suction in the one or more first suctions hole 814 by the suction device 84 is stopped. Thereafter, as illustrated in Fig. 6D, the second pressing plate 82 is moved away from the first pressing plate 81 while the suction in the one or more second suction holes 824 by the suction device 84 is maintained. As a result, the mask 20 is separated from the first pressing plate 81 and moves together with the second pressing plate 82 while remaining connected to the frame 60. Thereafter, the suction in the one or more second suction holes 824 by the suction device 84 is stopped.

Next, as illustrated in Fig. 6E, the opening/closing device 86 is operated to separate the second chamber element 852 from the first chamber element 851, thereby opening the chamber 85. Thereafter, the connection layer 70 is cured by cooling or the like, thereby fixing the mask 20 and the frame 60 to each other. In this way, the framed mask 15 can be obtained.

The above-described embodiment can be modified in various ways. Hereinafter, the modifications will be described with reference to the drawings as necessary. In the following description and the drawings used in the following description, parts that can be configured similarly to those of the above-described embodiment are denoted by the same reference signs as those used for corresponding parts in the above-described embodiment. Redundant description will be omitted. In addition, when it is apparent that the effects obtained in the above-described embodiment can also be obtained in the modifications, the description thereof may be omitted.

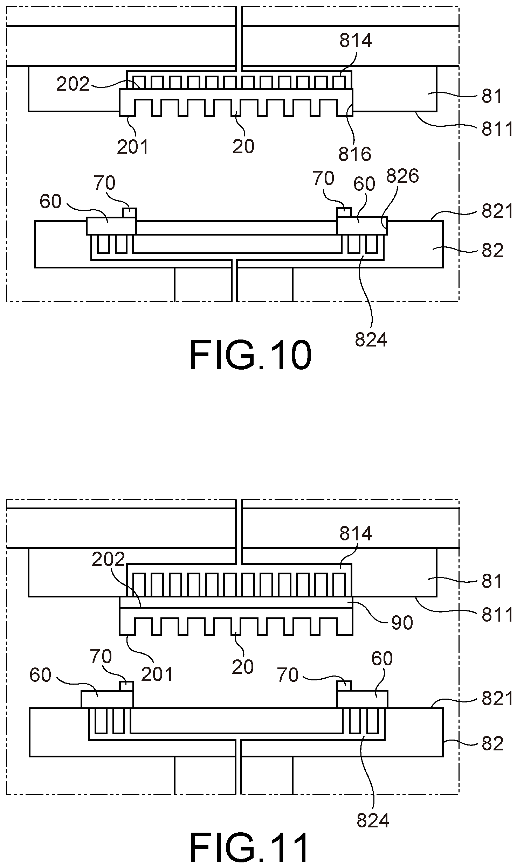

For example, as illustrated in Fig. 10, a first recess 816 that accommodates at least a part of the mask 20 in the thickness direction thereof may be formed in the first support surface 811 of the first pressing plate 81. The first recess 816 is formed in the inner region 812 of the first pressing plate 81. Since the first recess 816 is formed, the position of the mask 20 on the first support surface 811 can be easily adjusted when the mask 20 is disposed on the first support surface 811. That is, the position of the mask 20 on the first support surface 811 can be roughly adjusted simply by fitting the mask 20 into the first recess 816. The one or more first suction holes 814 may open in the first recess 816.

Further, as illustrated in Fig. 10, a second recess 826 that accommodates at least a part of the frame 60 in the thickness direction thereof may be formed in the second support surface 821 of the second pressing plate 82. The second recess 826 is formed in the inner region 822 of the second pressing plate 82. Since the second recess 826 is formed, the position of the frame 60 on the second support surface 821 can be easily adjusted when the frame 60 is disposed on the second support surface 821. That is, the position of the frame 60 on the second support surface 821 can be roughly adjusted simply by fitting the frame 60 into the second recess 826. The one or more second suction holes 824 and the one or more alignment openings 825 may open in the second recess 826.

By roughly adjusting the position of the mask 20 on the first support surface 811 and roughly adjusting the position of the frame 60 on the second support surface 821, the positions of the mask 20 and the frame 60 relative to each other can be roughly adjusted. In other words, the mask 20 and the frame 60 can be roughly aligned with respect to each other. As a result, it becomes easy to adjust the positions of the mask 20 and/or the frame 60 on the pressing plates 81 and 82 so that the alignment marks 39 and 69 overlap.

The depth of the first recess 816 only needs to be substantially equal to the thickness of the mask 20 or to be a depth that does not prevent the mask 20 and the frame 60 from being bonded to each other. That is, the depth of the first recess 816 only needs to be greater than 0 mm and less than or equal to the thickness of the mask 20, or, when the connection layer 70 is formed on the mask 20, less than or equal to the sum of the thickness of the mask 20 and the thickness of the connection layer 70. The depth of the first recess 816 may be, for example, 0.01 mm or more, 0.05 mm or more, or 0.1 mm or more. The depth of the first recess 816 may be, for example, 0.8 mm or less, 1 mm or less, or 2 mm or less. The range of the depth of the first recess 816 may be defined by a first group consisting of 0.01 mm, 0.05 mm, and 0.1 mm and/or a second group consisting of 0.8 mm, 1 mm, and 2 mm. The range of the depth of the first recess 816 may be defined by a combination of any one of the values included in the first group described above and any one of the values included in the second group described above. The range of the depth of the first recess 816 may be defined by a combination of any two of the values included in the first group described above. The range of the depth of the first recess 816 may be defined by a combination of any two of the values included in the second group described above. The depth of the first recess 816 may be, for example, 0.01 mm or more and 2 mm or less, 0.01 mm or more and 1 mm or less, 0.01 mm or more and 0.8 mm or less, 0.01 mm or more and 0.1 mm or less, 0.01 mm or more and 0.05 mm or less, 0.05 mm or more and 2 mm or less, 0.05 mm or more and 1 mm or less, 0.05 mm or more and 0.8 mm or less, 0.05 mm or more and 0.1 mm or less, 0.1 mm or more and 2 mm or less, 0.1 mm or more and 1 mm or less, 0.1 mm or more and 0.8 mm or less, 0.8 mm or more and 2 mm or less, 0.8 mm or more and 1 mm or less, or 1 mm or more and 2 mm or less.

The depth of the second recess 826 only needs to be substantially equal to the thickness T2 of the frame 60 or to be a depth that does not prevent the mask 20 and the frame 60 from being bonded to each other. That is, the depth of the second recess 826 only needs to be greater than 0 mm and less than or equal to the thickness T2 of the frame 60, or, when the connection layer 70 is formed on the frame 60, less than or equal to the sum of the thickness T2 of the frame 60 and the thickness of the connection layer 70. The depth of the second recess 826 may be, for example, 500 µm or more, 2 mm or more, or 5 mm or more. The depth of the second recess 826 may be, for example, 10 mm or less, 20 mm or less, or 30 mm or less. The range of the depth of the second recess 826 may be defined by a first group consisting of 500 µm, 2 mm, and 5 mm and/or a second group consisting of 10 mm, 20 mm, and 30 mm. The range of the depth of the second recess 826 may be defined by a combination of any one of the values included in the first group described above and any one of the values included in the second group described above. The range of the depth of the second recess 826 may be defined by a combination of any two of the values included in the first group described above. The range of the depth of the second recess 826 may be defined by a combination of any two of the values included in the second group described above. The depth of the second recess 826 may be, for example, 500 µm or more and 30 mm or less, 500 µm or more and 20 mm or less, 500 µm or more and 10 mm or less, 500 µm or more and 5 mm or less, 500 µm or more and 2 mm or less, 2 mm or more and 30 mm or less, 2 mm or more and 20 mm or less, 2 mm or more and 10 mm or less, 2 mm or more and 5 mm or less, 5 mm or more and 30 mm or less, 5 mm or more and 20 mm or less, 5 mm or more and 10 mm or less, 10 mm or more and 30 mm or less, 10 mm or more and 20 mm or less, or 20 mm or more and 30 mm or less.

As illustrated in Fig. 11, at least a part of the first support surface 811 of the first pressing plate 81 may be covered with a porous layer 90. In the illustrated example, the porous layer 90 covers the entire inner region 812 of the first support surface 811. In this case, the suction device 84 can suction the inside of the one or more first suction holes 814 and the inside of pores of the porous layer 90 to attract the mask 20 to the first pressing plate 81 via the porous layer 90. By attracting the mask 20 to the first pressing plate 81 via the porous layer 90, a uniform suction force can be applied over the entire exit surface 202 of the mask 20, and the flatness of the mask 20 can be improved.

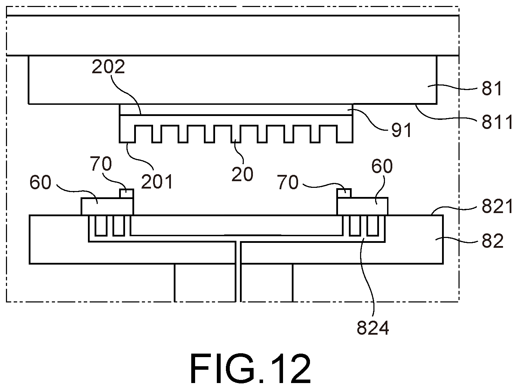

As illustrated in Fig. 12, at least a part of the first support surface 811 of the first pressing plate 81 may be covered with a bonding layer 91. The bonding layer 91 may be an adhesive layer or a tacky layer. The bonding layer 91 may be formed of a material that enables bonding at a low temperature. In the illustrated example, the bonding layer 91 covers the entire inner region 812 of the first support surface 811. In this case, the mask 20 can be held on the first pressing plate 81 by bonding the mask 20 to the first support surface 811 with the bonding layer 91. Further, by bonding the mask 20 to the flat inner region 812, the exit surface 202 of the mask 20 can be made flat. Therefore, in the example illustrated in Fig. 12, the first pressing plate 81 need not include any first suction holes 814. Note that the bonding layer 91 is preferably slightly tacky, so that after the mask 20 is connected to the connection layer 70, the mask 20 can be separated from the first pressing plate 81. Alternatively, the bonding layer 91 may be one whose bonding force decreases when heat, ultraviolet light, or laser light is applied. In this case, after the mask 20 is connected to the connection layer 70, the mask 20 can be separated from the first pressing plate 81 by applying heat, ultraviolet light, or laser light to the bonding layer 91. After the mask 20 is connected to the connection layer 70, the mask 20 may be separated from the first pressing plate 81 by separating the second pressing plate 82 from the first pressing plate 81 while the frame 60 remains attracted to the second pressing plate 82.

The connection apparatus 80 according to the embodiment described above is an apparatus for connecting a frame 60 to a mask 20. The mask 20 has an inner region 26 and an outer region 25 surrounding the inner region 26. A plurality of openings 31 and 41 are formed in the inner region 26. The frame 60 is to be connected to the outer region 25. The connection apparatus 80 includes a first pressing plate 81, a suction device 84, a second pressing plate 82, and a pressing device 83. The first pressing plate 81 includes a first support surface 811 for supporting the mask 20. The first pressing plate 81 is provided with a first suction hole 814 that opens in the first support surface 811. The suction device 84 is configured to suction the inside of the first suction hole 814. The second pressing plate 82 includes a second support surface 821 for supporting the frame 60. The second support surface 821 faces toward the first support surface 811. The pressing device 83 is configured to move the first pressing plate 81 and/or the second pressing plate 82 to press the first pressing plate 81 and the second pressing plate 82 against each other.

The connection method according to the embodiment described above is a method for connecting a frame 60 to a mask 20 by using the connection apparatus 80 according to the embodiment. The mask 20 has an inner region 26 and an outer region 25 surrounding the inner region 26. A plurality of openings 31 and 41 are formed in the inner region 26. The frame 60 is to be connected to the outer region 25. The connection method includes a step of disposing the mask 20 on the first support surface 811 of the first pressing plate 81 and holding the mask 20 on the first support surface 811 by suctioning the inside of the first suction hole 814 by the suction device 84. The connection method further includes a step of disposing the frame 60 on the second support surface 821 of the second pressing plate 82. The connection method further includes a step of forming a connection layer 70 in the outer region 25 of the mask 20 or in a region 67 of the frame 60 that is to face the outer region 25. The connection method further includes a step of connecting the mask 20 and the frame 60 via the connection layer 70 by moving the first pressing plate 81 on which the mask 20 is held by suction and/or the second pressing plate 82 supporting the frame 60 by the pressing device 83 to press the first pressing plate 81 and the second pressing plate 82 against each other.

According to the connection apparatus 80 and the connection method according to the embodiment, the flatness of the mask 20 in the framed mask 15 can be improved.

The connection apparatus 80 according to a modification of the embodiment described above is an apparatus for connecting a frame 60 to a mask 20. The mask 20 has an inner region 26 and an outer region 25 surrounding the inner region 26. A plurality of openings 31 and 41 are formed in the inner region 26. The frame 60 is to be connected to the outer region 25. The connection apparatus 80 includes a first pressing plate 81, a second pressing plate 82, and a pressing device 83. The first pressing plate 81 includes a first support surface 811 for supporting the mask 20. The second pressing plate 82 includes a second support surface 821 for supporting the frame 60. The second support surface 821 faces the first support surface 811. The pressing device 83 is configured to move the first pressing plate 81 and/or the second pressing plate 82 to press the first pressing plate 81 and the second pressing plate 82 against each other. At least a part of the first support surface 811 of the first pressing plate 81 is covered with a bonding layer 91.

The connection method according to a modification of the embodiment described above is a method for connecting a frame 60 to a mask 20 by using the connection apparatus 80 according to the modification of the embodiment. The mask 20 has an inner region 26 and an outer region 25 surrounding the inner region 26. A plurality of openings 31 and 41 are formed in the inner region 26. The frame 60 is to be connected to the outer region 25. The connection method includes a step of disposing the mask 20 on the first support surface 811 of the first pressing plate 81 and bonding the mask 20 to the bonding layer 91. The connection method further includes a step of disposing the frame 60 on the second support surface 821 of the second pressing plate 82. The connection method further includes a step of forming a connection layer 70 in the outer region 25 of the mask 20 or in a region 67 of the frame 60 that is to face the outer region 25. The connection method further includes a step of connecting the mask 20 and the frame 60 via the connection layer 70 by moving the first pressing plate 81 to which the mask 20 is bonded and/or the second pressing plate 82 supporting the frame 60 by the pressing device 83 to press the first pressing plate 81 and the second pressing plate 82 against each other.

According to the connection apparatus 80 and the connection method according to the modification of the embodiment, the flatness of the mask 20 in the framed mask 15 can be improved.

It is also possible to appropriately combine a plurality of components disclosed in the above embodiments and modifications as necessary. Alternatively, some components may be deleted from all the components disclosed in the above embodiments and modifications.

## Claims

1. A connection apparatus for connecting a frame to an outer region of a mask that includes an inner region in which a plurality of openings are formed and the outer region surrounding the inner region, the connection apparatus comprising:
a first pressing plate including a first support surface for supporting the mask, the first pressing plate being provided with a first suction hole that opens in the first support surface;
a suction device configured to suction an inside of the first suction hole;
a second pressing plate including a second support surface for supporting the frame, the second support surface facing toward the first support surface; and
a pressing device configured to move the first pressing plate and/or the second pressing plate to press the first pressing plate and the second pressing plate against each other.

2. The connection apparatus according to claim 1, wherein at least a part of the first support surface of the first pressing plate is covered with a porous layer.

3. The connection apparatus according to claim 1, wherein the second pressing plate is provided with a second suction hole that opens in the second support surface, and wherein
the suction device is configured to suction an inside of the second suction hole.

4. A connection apparatus for connecting a frame to an outer region of a mask that includes an inner region in which a plurality of openings are formed and the outer region surrounding the inner region, the connection apparatus comprising:
a first pressing plate including a first support surface for supporting the mask;
a second pressing plate including a second support surface for supporting the frame, the second support surface facing toward the first support surface; and
a pressing device configured to move the first pressing plate and/or the second pressing plate to press the first pressing plate and the second pressing plate against each other,
wherein at least a part of the first support surface of the first pressing plate is covered with a bonding layer.

5. The connection apparatus according to claim 4, wherein the second pressing plate is provided with a second suction hole that opens in the second support surface, and
the connection apparatus further comprises a suction device configured to suction an inside of the second suction hole.

6. The connection apparatus according to claim 1 or 4, wherein a first recess that accommodates at least a part of the mask in a thickness direction thereof is formed in the first support surface.

7. The connection apparatus according to claim 6, wherein a depth of the first recess is greater than 0 µm and 1000 µm or less.

8. The connection apparatus according to claim 1 or 4, wherein a second recess that accommodates at least a part of the frame in a thickness direction thereof is formed in the second support surface.

9. The connection apparatus according to claim 8, wherein a depth of the second recess is greater than 0 µm and 30 mm or less.

10. The connection apparatus according to claim 1 or 4, further comprising one or more heaters provided inside the first pressing plate and/or the second pressing plate.

11. The connection apparatus according to claim 1 or 4, further comprising:
a chamber that accommodates the first pressing plate and the second pressing plate; and
a pressure reducing device configured to reduce a pressure in the chamber.

12. The connection apparatus according to claim 1 or 4, wherein the second pressing plate is provided with an alignment opening penetrating through the second pressing plate in a thickness direction thereof, and
the connection apparatus further comprises an alignment camera configured to capture an image between the second support surface and the first support surface through the alignment opening.

13. A connection method for connecting a frame to an outer region of a mask that includes an inner region in which a plurality of openings are formed and the outer region surrounding the inner region, by using the connection apparatus according to claim 1, the connection method comprising:
a step of disposing the mask on the first support surface of the first pressing plate and holding the mask on the first support surface by suctioning the inside of the first suction hole by the suction device;
a step of disposing the frame on the second support surface of the second pressing plate;
a step of forming a connection layer in the outer region of the mask or in a region of the frame that is to face the outer region; and
a step of connecting the mask and the frame via the connection layer by moving the first pressing plate on which the mask is held by suction and/or the second pressing plate supporting the frame by the pressing device to press the first pressing plate and the second pressing plate against each other.

14. The connection method according to claim 13, further comprising a step of stopping suction of the inside of the first suction hole by the suction device after connecting the mask and the frame.

15. A connection method for connecting a frame to an outer region of a mask that includes an inner region in which a plurality of openings are formed and the outer region surrounding the inner region, by using the connection apparatus according to claim 4, the connection method comprising:
a step of disposing the mask on the first support surface of the first pressing plate and bonding the mask to the bonding layer;
a step of disposing the frame on the second support surface of the second pressing plate;
a step of forming a connection layer in the outer region of the mask or in a region of the frame that is to face the outer region; and
a step of connecting the mask and the frame via the connection layer by moving the first pressing plate to which the mask is bonded and/or the second pressing plate supporting the frame by the pressing device to press the first pressing plate and the second pressing plate against each other.

16. The connection method according to claim 13 or 15, wherein the second pressing plate is provided with a second suction hole that opens in the second support surface,
the connection apparatus includes a suction device configured to suction an inside of the second suction hole, and
the connection method further comprises a step of suctioning the inside of the second suction hole by the suction device after disposing the frame on the second pressing plate.

17. The connection method according to claim 13 or 15, wherein one or more heaters are provided inside the first pressing plate and/or the second pressing plate, and
during the step of pressing the first pressing plate and the second pressing plate against each other, the first pressing plate and/or the second pressing plate is heated by the one or more heaters.

18. The connection method according to claim 13 or 15, wherein the connection apparatus further includes
a chamber that accommodates the first pressing plate and the second pressing plate, and
a pressure reducing device configured to reduce a pressure in the chamber, and
during the step of pressing the first pressing plate and the second pressing plate against each other, the pressure in the chamber is reduced by the pressure reducing device.

19. The connection method according to claim 13 or 15, wherein alignment marks are formed on the mask and the frame,
the second pressing plate is provided with an alignment opening penetrating through the second pressing plate in a thickness direction thereof,
the connection apparatus further includes an alignment camera configured to capture an image between the second support surface and the first support surface through the alignment opening, and
during the step of disposing the frame on the second support surface of the second pressing plate, alignment of the mask and the frame is performed by capturing an image of the alignment marks of the mask and the frame with the alignment camera through the alignment opening.
